(19) Europäisches Patentamt
European Patent Office
Office européen des brevets

(11) EP 3 419 051 B1

(12) EUROPEAN PATENT SPECIFICATION

(45) Date of publication and mention of the grant of the patent:
**08.04.2026 Bulletin 2026/15**

(21) Application number: **17753076.3**

(22) Date of filing: **09.02.2017**

(51) International Patent Classification (IPC):
***H01L 23/12*** *(2006.01)* ***C08L 101/00*** *(2006.01)*
***H01L 23/00*** *(2006.01)* ***C08J 3/24*** *(2006.01)*

(52) Cooperative Patent Classification (CPC):
**C08J 3/243; C08J 3/244; C08L 101/00; H10W 70/60; H10W 99/00;** H10W 72/0198; H10W 72/241

(86) International application number:
**PCT/JP2017/004777**

(87) International publication number:
**WO 2017/141818 (24.08.2017 Gazette 2017/34)**

# (54) CURABLE RESIN COMPOSITION AND FAN OUT TYPE WAFER LEVEL PACKAGE

HÄRTBARE HARZZUSAMMENSETZUNG UND WAFEREBENENGEHÄUSE VOM AUFFÄCHERUNGSTYP

COMPOSITION DE RÉSINE DURCISSABLE ET GROUPE AU NIVEAU D'UNE PLAQUETTE EN ÉVENTAIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.02.2016 JP 2016028046**

(43) Date of publication of application:
**26.12.2018 Bulletin 2018/52**

(73) Proprietor: **TAIYO HOLDINGS CO., LTD.**
**Saitama-ken (JP)**

(72) Inventors:
- **FUNAKOSHI, Chihiro**
  **Hiki-gun**
  **Saitama 355-0215 (JP)**
- **SATO, Kazuya**
  **Hiki-gun**
  **Saitama 355-0215 (JP)**
- **ITO, Nobuhito**
  **Hiki-gun**
  **Saitama 355-0215 (JP)**

(74) Representative: **Hoffmann Eitle**
**Patent- und Rechtsanwälte PartmbB**
**Arabellastraße 30**
**81925 München (DE)**

(56) References cited:
**JP-A- 2004 099 635** **JP-A- 2004 253 643**
**JP-A- 2011 075 787** **JP-A- 2013 168 615**
**US-A1- 2010 167 471** **US-A1- 2010 252 919**

- **JIAN ET AL: "Thiol-epoxy/thiol-acrylate hybrid materials synthesized by photopolymerization", JOURNAL OF MATERIALS CHEMISTRY C,, no. 1, 17 June 2013 (2013-06-17), pages 4481 - 4489, XP002769443, DOI: 10.1039/C3TC30360H**
- **CARIOSCIA ET AL: "Evaluation and control of thiol-ene/thiol-epoxy hybrid networks", POLY, ELSEVIER SCIENCE PUBLISHERS B.V, GB, vol. 48, no. 6, 8 March 2007 (2007-03-08), pages 1526 - 1532, XP005909537, ISSN: 0032-3861, DOI: 10.1016/J.POLYMER.2007.01.044**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 419 051 B1

## Description

BACKGROUND OF THE INVENTION

[Field of the Invention]

The present invention relates to curable resin compositions. More particularly, the invention relates to curable resin compositions leading to reduction in warpage of a semiconductor wafer or a semiconductor package; in particular, the invention relates to a curable resin composition used for forming a warpage correction layer that is disposed on the face opposite to the redistribution layer of a fan-out wafer level package, in which a mounting area of electrodes for external connections is larger than the horizontal size of the semiconductor.

[Background Art]

In recent years, demands for downsizing have been swelling in the field of semiconductor circuits, etc., and a semiconductor circuit is sometimes put into a package (Chip Size Package) with a size close to the chip size in order to meet the demand. As one of means for realizing a chip size package, a packaging method called a wafer level package (hereinafter occasionally abbreviated as WLP), which is bonded together at the wafer level and fragmented, has been proposed. The WLP has been attracting attention, because it can contribute to reduction of the cost and size. A WLP is mounted face down on a circuit board on which electrodes are formed.

Incidentally, along with downsizing and highly advanced integration of a semiconductor chip, the number of electrodes (terminals or bumps) for external connections of the semiconductor chip tends to increase, and therefore, the pitch of the electrodes for external connections tends to become smaller. However, it is not always easy to mount a semiconductor chip, on which bumps are formed with a fine pitch, directly on a circuit board.

In order to overcome such a problem as described above, a method, by which a region of a semiconductor encapsulant is formed on the outer periphery of a semiconductor chip, and a redistribution layer connected to electrodes is formed also in the region of a semiconductor encapsulant so as to increase the pitch of the bumps, has been proposed. Since the size of the mounting area for bumps is larger than the size of the semiconductor chip, such a WLP is called a fan-out wafer level package (hereinafter occasionally abbreviated as "FO-WLP").

In a FO-WLP, a semiconductor chip is embedded with a semiconductor encapsulant. The circuit surface of the semiconductor chip is exposed outward and the boundary between the semiconductor chip and the semiconductor encapsulant is formed. A redistribution layer connected with electrodes of the semiconductor chip is also provided in the region of the semiconductor encapsulant embedding the semiconductor chip, and the bumps are electrically connected with the electrodes of the chip via the redistribution layer. By this means, the pitch of the bumps can be set larger than the pitch of the electrodes of the semiconductor chip.

Further, it is conceivable that not only a semiconductor chip, but also electronic components are placed in a package, or semiconductor chips are embedded in a semiconductor encapsulant to form an integrated semiconductor component. In such a package, electronic components are embedded with a semiconductor encapsulant. The semiconductor encapsulant embedding a plurality of electronic components is provided with a redistribution layer electrically connected with the electrodes of the electronic components, and the bumps are electrically connected with the electrodes of the electronic components via the redistribution layer. Also, in this case, it may be regarded as a FO-WLP, because the size of the mounting area for bumps is larger than the size of the semiconductor chip.

In such a package, semiconductor chips and electronic components are generally placed on a support with predetermined intervals and embedded with a semiconductor encapsulant, the encapsulant is cured by heating, and then the support is peeled off to yield a pseudo wafer. Subsequently, a redistribution layer is formed from the circuit surface of a semiconductor chip to the extended semiconductor encapsulant material region of the pseudo wafer. In this way, the pitch of the bumps can be set larger than the pitch of the electrodes of the semiconductor chips.

For forming a redistribution layer, generally, a positive type sensitive resin is applied to the circuit surface of semiconductor chips of a pseudo wafer, prebaked, and subjected to irradiation, by which a region to be opened is irradiated with actinic rays such as UV rays through a photomask or the like, then to development using a developing solution such as TMAH (tetramethylammonium hydroxide), to heat curing, to an oxygen plasma treatment or the like, and to sputtering for metal electrodes, and further a redistribution layer is formed by forming a photoresist layer and patterning the wiring (for example, Patent Literature 1).

When a redistribution layer is formed on the circuit face of a semiconductor chip in a WLP or FO-WLP, the circuit face (that is, the face on which an insulation film is formed) is deformed to have concave warpage, mainly because the insulation film including a photosensitive polyimide in the wiring shrinks during curing of the insulation film. One proposed solution to reduce the amount of warpage includes forming a resin layer on one face of a substrate made of a wafer-shaped semiconductor, warping and retaining the substrate such that the entire resin layer is spherically bulged, and then curing

the resin layer (for example, Patent Literature 2).

Examples of compositions comprising two curable components having different volume contraction through curing are described in Non Patent Literature 1 and 2.

[Citation List]

Patent Literature

Patent Literature 1: Japanese Patent Application Publication No. 2013-38270
Patent Literature 2: Japanese Patent Application Publication No. 2012-178422

Non Patent Literature

Non Patent Literature 1: Caroscia, et al., "Evaluation and control of thiol-ene/thiol-epoxy hybrid networks", Polymer, vol. 48, no. 6, March 2007, pages 1526-1532
Non Patent Literature 2: Jian, et al., "Thiol-epoxy/thiol-acrylate hybrid materials synthesized by photo polymerization", Journal of Materials Chemistry C, vol. 1, June 2013 (2013-06-17), pages 4481-4489

SUMMARY OF THE INVENTION

[Technical Problem]

However, in spite of reducing the amount of warpage by heating the WLP having a redistribution layer disposed only on one face as described above, the redistribution layer will expand when heated at a WLP mounting temperature (260°C, for example), with the result that warpage occurs in the package. Consequently, there arise problems including interlayer peeling inside the package and difficulties in connecting some terminals during mounting. On the other hand, if an adjustment is made so as to reduce the amount of warpage at a WLP mounting temperature for the purpose of reducing warpage of the package during the WLP mounting, warpage will occur in the wafer when the package is cooled to room temperature, because of shrinkage of the redistribution layer that includes the insulation film. Consequently, there arise problems including difficulties in conveying wafers and higher risk of causing stress to break the wafers with a slight shock.

Accordingly, an object of the present invention is to provide a curable resin composition that leads to reduced warpage of a wafer or package by adjusting the amount of warpage both at a temperature for mounting a semiconductor wafer or a semiconductor package, in particular, a fan-out wafer level package (FO-WLP), and at room temperature for, for example, conveying wafers. Another object of the present invention is to provide a fan-out wafer level package that includes a warpage correction layer made of a cured product of the curable resin composition.

[Solution to Problem]

To solve the problems described above, it may be desirable that the amount of warpage is reduced both at a temperature for mounting a semiconductor package and at room temperature for, for example, conveying wafers. The present inventors have found that the above problems can be solved by forming a warpage correction layer on the face opposite to the face on which a wafer redistribution layer is formed, where the warpage correction layer has a contraction force countervailing the stress of shrinkage caused by, for example, curing the insulation film in the redistribution layer. Since semiconductor wafers and FO-WLP pseudo wafers have various thicknesses, and redistribution layers including insulation films also have a wide variety of thicknesses and patterns, the present inventors have further found that it is advantageous to dispose a versatile warpage correction layer on the face opposite to the face on which the redistribution layer including an insulation film is formed, where the versatile warpage correction layer allows for adjustments appropriate for the respective amounts of warpage. Finally, the inventors have found that warpage of a wafer or package can be reduced while the amount of warpage of the wafer or package is adjusted, by forming the warpage correction layer using a curable resin composition described below.

A curable resin composition according to the present invention is curable through at least two types of curing reactions,, the curable resin composition comprising:

a combination of a curable component (A1) that contracts in volume through one curing reaction, a heat curing agent

component (A2-1) capable of curing the curable component (A1), a curable component (B1) that contracts in volume through another curing reaction, and a light curing agent component (B2-2) capable of curing the curable component (B1),

wherein the one curing reaction is an ionic ring-opening polymerization reaction or a polyaddition polymerization reaction, and the other curing reaction is a radical addition polymerization reaction,

wherein a volume contraction ratio A (%) of the curable component (A1) that is cured through the ionic ring-opening polymerization reaction or the polyaddition polymerization reaction to contract in volume is within a range of $0 < A \leq 7$,

wherein a volume contraction ratio B (%) of the curable component (B1) that is cured through the radical addition polymerization reaction to contract in volume is within a range of $5 \leq B \leq 30$, and

wherein the volume contraction ratio A and the volume contraction ratio B satisfy an expression below:

$$A < B.$$

In an embodiment of the present invention, the curable resin composition is used for forming a warpage correction layer that is disposed on a face opposite to a face on which a redistribution layer of a FO-WLP is disposed.

A fan-out wafer level package according to an embodiment of the present invention includes:

a semiconductor chip, on one face of which a circuit is formed;
an encapsulant that seals the semiconductor chip such that at least a circuit terminal on the face on which the circuit is formed is exposed;
a redistribution layer disposed on a circuit forming face of the encapsulant; and
a warpage correction layer disposed on a face of the encapsulant, the face being opposite to the face on which the redistribution layer is disposed,
wherein the warpage correction layer includes a cured product of the curable resin composition.

[Advantageous Effects of Invention]

According to the present invention, in a FO-WLP among others, the amount of warpage can be reduced both at a temperature for mounting a semiconductor package and at room temperature for, for example, conveying wafers, by forming a warpage correction layer on the face opposite to the face on which a redistribution layer is disposed, using a curable resin composition that includes a curable component (A1) that contracts in volume through one curing reaction and a curable component (B1) that contracts in volume through another curing reaction, and warpage of a wafer or a package can be reduced by adjusting the amount of warpage of the wafer or the package. As a result, semiconductor packages of high quality and reliability can be obtained.

## DETAILED DESCRIPTION OF THE INVENTION

A curable resin composition according to the present invention is curable through at least two types of curing reactions, the curable resin composition comprising:

a combination of a curable component (A1) that contracts in volume through one curing reaction, a heat curing agent component (A2-1) capable of curing the curable component (A1), a curable component (B1) that contracts in volume through another curing reaction, and a light curing agent component (B2-2) capable of curing the curable component (B1),

wherein the one curing reaction is an ionic ring-opening polymerization reaction or a polyaddition polymerization reaction, and the other curing reaction is a radical addition polymerization reaction,

wherein a volume contraction ratio A (%) of the curable component (A1) that is cured through the ionic ring-opening polymerization reaction or the polyaddition polymerization reaction to contract in volume is within a range of $0 < A \leq 7$,

wherein a volume contraction ratio B (%) of the curable component (B1) that is cured through the radical addition

polymerization reaction to contract in volume is within a range of $5 \leq B \leq 30$, and

wherein the volume contraction ratio A and the volume contraction ratio B satisfy an expression below:

$$A < B.$$

The amount of warpage can be reduced both at a temperature for mounting a semiconductor package and at room temperature for, for example, conveying wafers, by using the curable resin composition according to the present invention to form a warpage correction layer on the face opposite to the face on which the redistribution layer of a FO-WLP is disposed, and by adjusting the volume contraction ratio of the warpage correction layer so that a contraction stress comparable to the contraction stress on the redistribution layer is exerted. In sum, during production of a FO-WLP, a redistribution layer along with an insulation layer is disposed on the circuit forming face of a pseudo wafer, resulting in different degrees of warpage occurring on the pseudo wafer depending on the material, thickness, and pattern of the insulation film. In spite of such warpage, as in the present invention, by disposing a warpage correction layer on the face opposite to the face on which the redistribution layer is formed, using a curable resin composition that contains curable components curable through at least two types of curing reactions, and by curing the curable resin composition to form the warpage correction layer while controlling at least two types of curing reactions, the warpage correction layer is capable of generating a contraction stress comparable to the stress acting on the FO-WLP through volume contraction of the insulation layer. Therefore, the amount of warpage can be reduced both at a temperature for mounting a semiconductor package and at room temperature for, for example, conveying wafers. In addition, a wafer or a package can be less warped by adjusting the amount of warpage of the wafer or package. As a result, it is believed that semiconductor packages of high quality and reliability can be obtained. The above is only a presumption by the present inventors, and the present invention is not bound by the said logic. Individual components forming the curable resin composition according to the present invention will now be described.

<Curable Component (A1)>

As a curable component (A1) that contracts in volume through a curing reaction, any conventionally known material may be used without restriction as long as the material has such curable properties that the material contracts in volume through a curing reaction; however, the curable component has ionic ring-opening polymerization reactivity or polyaddition polymerization reactivity. Ionic ring-opening polymerization, as used herein, refers to the polymerization in which a polymerization reaction is caused to proceed using a ring-opening monomer for polymerization, with the growing chain being ionic. Polyaddition reaction, as used herein, refers to the reaction in which polymerization proceeds while an addition reaction is repeated where a monomer having at least two functional groups each having a cyclic structure or a cumulative double bond is combined with a monomer having, at each of its ends, a functional group that can react with such functional group having a cyclic structure or a cumulative double bond. Note that a protecting group may further be attached to the aforementioned cumulative double bond. As a curable component having ionic ring-opening polymerization reactivity or polyaddition polymerization reactivity as described above, a cyclic ether, such as epoxy and oxetane, and an isocyanate compound or a blocked isocyanate compound are preferably used. Among others, an epoxy resin or a blocked isocyanate compound is preferably used.

Epoxy resins are classified into a solid, a semi-solid, and a liquid epoxy resin based on the shape before reaction. These may be used singly or in combination of two or more thereof. When such cyclic ether is contained as the curable component (A1), the curable component (A1) will better stick to the pseudo wafer when cured as described later, thereby contributing to further reduction in warpage of a FO-WLP.

Examples of a solid epoxy resin include a naphthalene epoxy resin, such as HP-4700 manufactured by DIC Corporation (naphthalene epoxy resin), EXA 4700 manufactured by DIC Corporation (tetrafunctional naphthalene epoxy resin), and NC-7000 manufactured by Nippon Kayaku Co., Ltd. (polyfunctional solid epoxy resin containing a naphthalene skeleton); an epoxidized product (trisphenol epoxy resin) of a condensation product of a phenol with an aromatic aldehyde having a phenolic hydroxyl group, such as EPPN-502H manufactured by Nippon Kayaku Co., Ltd. (trisphenol epoxy resin); a dicyclopentadiene aralkyl epoxy resin, such as EPICLON HP-7200H manufactured by DIC Corporation (a polyfunctional solid epoxy resin having a dicyclopentadiene skeleton); a biphenyl aralkyl epoxy resin, such as NC-3000H manufactured by Nippon Kayaku Co., Ltd. (polyfunctional solid epoxy resin having a biphenyl skeleton); a biphenyl/phenol novolak epoxy resin such as NC-3000L manufactured by Nippon Kayaku Co., Ltd.; a novolak epoxy resin, such as EPICLON N660, EPICLON N690 manufactured by DIC Corporation, and EOCN-104S manufactured by Nippon Kayaku Co., Ltd.; a biphenyl epoxy resin, such as YX-4000 manufactured by Mitsubishi Chemical Corporation; a phosphorus-containing epoxy resin, such as TX0712 manufactured by Nippon Steel & Sumikin Chemical Co., Ltd.; tris(2,3-epoxypropyl)isocyanurate, such as TEPIC manufactured by Nissan Chemical Ind., Ltd.; and bisphenol A epoxy resin, such as jER 1007 manufactured by Mitsubishi Chemical Corporation.

Examples of a semi-solid epoxy resin include a bisphenol A epoxy resin, such as EPICLON 860, EPICLON 900-IM, EPICLON EXA-4816, and EPICLON EXA-4822 manufactured by DIC Corporation, EPOTOHTO YD-134 manufactured by Tohto Chemical Industry Co., Ltd., jER 834 and jER 872 manufactured by Mitsubishi Chemical Corporation, and ELA-134 manufactured by Sumitomo Chemical Co., Ltd.; a naphthalene epoxy resin, such as EPICLON HP-4032 manufactured by DIC Corporation; and a phenol novolak epoxy resin, such as EPICLON N-740 and EPICLON N-770 manufactured by DIC Corporation.

Examples of a liquid epoxy resin include a bisphenol A epoxy resin such as jER 828 manufactured by Mitsubishi Chemical Corporation, a bisphenol F epoxy resin, a bisphenol AF epoxy resin, a phenol novolak epoxy resin, a tert-butyl catechol epoxy resin, a glycidyl amine epoxy resin, an aminophenol epoxy resin, and an alicyclic epoxy resin.

An isocyanate compound or a blocked isocyanate compound is a compound having a plurality of isocyanate groups or blocked isocyanate groups in a single molecule. Examples of such compound having a plurality of isocyanate groups or blocked isocyanate groups in a single molecule include a polyisocyanate compound or a blocked isocyanate compound. A blocked isocyanate group is a group protected and temporarily inactivated by the reaction of an isocyanate group with a blocking agent, and, when heated to a certain temperature, the blocked isocyanate group releases the blocking agent to generate an isocyanate group. It has been found that curing ability and strength of an obtained cured product can be improved by adding a polyisocyanate compound or a blocked isocyanate compound as described above. Examples of such polyisocyanate compound include an aromatic polyisocyanate, an aliphatic polyisocyanate, and an alicyclic polyisocyanate.

Specific examples of the aromatic polyisocyanate include 4,4'-diphenylmethane diisocyanate, 2,4-tolylene diisocyanate, 2,6-tolylene diisocyanate, naphthalene-1,5-diisocyanate, o-xylylene diisocyanate, m-xylylene diisocyanate, and 2,4-tolylene dimer.

Specific examples of the aliphatic polyisocyanate include tetramethylene diisocyanate, hexamethylene diisocyanate, methylene diisocyanate, trimethylhexamethylene diisocyanate, 4,4-methylene-bis(cyclohexylisocyanate), and isophorone diisocyanate.

Specific examples of the alicyclic polyisocyanate include bicycloheptane triisocyanate. In addition, an adduct, a biuret, and an isocyanurate of the aforementioned isocyanate compounds are included in the examples.

As a blocked isocyanate compound, a product of the addition reaction of an isocyanate compound with an isocyanate blocking agent is used. Examples of an isocyanate compound that can react with a blocking agent include the above-mentioned polyisocyanate compounds.

Examples of a blocking agent for forming a blocked isocyanate group include a phenolic blocking agent such as phenol, cresol, xylenol, chlorophenol, or ethyl phenol; a lactam blocking agent such as ε-caprolactam, δ-valerolactam, γ-butyrolactam, or β-propiolactam; an active methylene blocking agent such as ethyl acetoacetate or acetylacetone; an alcohol blocking agent such as methanol, ethanol, propanol, butanol, amyl alcohol, ethylene glycol monomethyl ether, ethylene glycol monoethyl ether, ethylene glycol monobutyl ether, diethylene glycol monomethyl ether, propylene glycol monomethyl ether, benzyl ether, methyl glycolate, butyl glycolate, diacetone alcohol, methyl lactate, or ethyl lactate; an oxime blocking agent such as formamidoxime, acetaldoxime, acetoxime, methyl ethyl ketoxime, diacetyl monoxime, or cyclohexane oxime; a mercaptan blocking agent such as butyl mercaptan, hexyl mercaptan, t-butyl mercaptan, thiophenol, methylthiophenol, or ethylthiophenol; an acid amide blocking agent such as acetic acid amide or benzamide; an imide blocking agent such as succinimide or maleic acid imide; an amine blocking agent such as xylidine, aniline, butylamine, or dibutylamine; an imidazole blocking agent such as imidazole or 2-ethylimidazole; and an imine blocking agent such as methyleneimine or propyleneimine.

Commercially supplied blocked isocyanate compounds may be used, including, for example, SUMIDUR BL-3175, BL-4165, BL-1100, BL-1265, Desmodur TPLS-2957, TPLS-2062, TPLS-2078, TPLS-2117, Desmotherm 2170, and Desmotherm 2265 (all of which are manufactured by Sumitomo Bayer Urethane Co., Ltd.), Coronate 2512, Coronate 2513, and Coronate 2520 (all of which are manufactured by Nippon Polyurethane Industry Co., Ltd.), B-830, B-815, B-846, B-870, B-874, and B-882 (all of which are manufactured by Mitsui Takeda Chemicals, Inc.), and TPA-B80E, 17B-60PX, and E402-B80T (all of which are manufactured by Asahi Kasei Chemicals Corporation). Note that Sumidur BL-3175 and BL-4265 are obtained by using methylethyl oxime as a blocking agent.

The above curable components (A1) may be used singly or in combination of two or more thereof.

The curable resin composition according to the present invention includes a curing agent component (A2) capable of curing the curable component (A1). The curing agent component (A2) is a curing agent component (A2-1) that can cause the curable component (A1) to undergo an ionic ring-opening polymerization reaction or a polyaddition polymerization reaction with heat. Also disclosed is a curing agent component (A2-2) that is not according to the claimed invention and can cause the curable component (A1) to undergo an ionic ring-opening polymerization reaction or a polyaddition polymerization reaction with active energy rays. The curing agent component A2-1 is appropriately selected depending on the combination with a curing agent component (B2) capable of curing a curable component (B1), which is

described later. For example, when the curable component (A1) is intended to undergo polymerization, a curing agent component can be selected so that the curable component (B1) is prevented from developing a curing reaction in conjunction with the curing reaction of the curable component (A1). Active energy rays, as used herein, refer to electromagnetic waves having a necessary level of energy for a curing agent component to excite the state from the ground state to the transition state, such as electron rays, ultraviolet rays, or visible rays.

As an example of the curing agent component (A2-1) that can cause the curable component (A1) to undergo ionic ring-opening polymerization with heat, an imidazole, a benzylsulfonium salt, or a Lewis acid-amine complex may be used. Among others, it is preferable to use an imidazole from the viewpoint of adhesion to a pseudo wafer, preservation stability, moisture-resistance reliability, and the like.

Examples of an imidazole include 2MZ, C11Z, 2PZ, 2E4MZ, 2P4MZ, 1B2MZ, 1B2PZ, 2MZ-CN, 2E4MZ-CN, 2PZ-CN, C11Z-CN, 2PZ-CNS, C11Z-CNS, 2MZ-A, C11Z-A, 2E4MZ-A, 2P4MHZ, 2PHZ, 2MA-OK, and 2PZ-OK (trade names, supplied by Shikoku Chemicals Corporation), as well as compounds produced by adding an epoxy resin to any of these imidazoles. In addition, these curing agents are preferably coated with, for example, a polyurethane-based or polyester-based polymer material to be microencapsulated because of a prolonged usable life. These may be used singly, or in a mixture of two or more thereof.

The content of an imidazole is preferably 0.1 to 10% by mass with respect to the curable component (A-1), more preferably 0.5 to 10% by mass, and further preferably 1 to 10% by mass. By adjusting the content of an imidazole, which is a curing agent component (A2-1) that can cause ionic ring-opening polymerization, within the above-mentioned range, both curing ability and preservation stability can be achieved.

As examples of the benzylsulfonium salt, Sanshin Chemical SAN AID Series, namely, SI-45, SI-60, SI-80, SI-100, SI-150, SI-110, SI-360, SI-360, SI-B2A, SI-B3A, SI-B3, SI-B4, and SI-B5 may be used. These may be used singly, or in a mixture of two or more thereof.

The content of a benzylsulfonium salt is preferably 0.1 to 10% by mass with respect to the curable component (A-1), more preferably 0.5 to 10% by mass, and further preferably 1 to 10% by mass. By adjusting the content of a benzylsulfonium salt, which is a curing agent component (A2-1) that can cause ionic ring-opening polymerization, within the above-mentioned range, both curing ability and preservation stability can be achieved.

As an example of a Lewis acid-amine complex, any known complex such as a BF3-triethylamine complex or a BF3-pyridine complex may be used.

The content of a curing agent component (A2-1) such as a Lewis acid-amine complex is preferably 0.1 to 10% by mass with respect to the curable component (A-1), more preferably 0.5 to 10% by mass, and further preferably 1 to 10% by mass. By adjusting the content of a Lewis acid-amine complex, which is a curing agent component (A2-1) that can cause ionic ring-opening polymerization, within the above-mentioned range, both curing ability and preservation stability can be achieved.

The curable component (A1) may also be cured through a polyaddition polymerization reaction. As an example of the curing agent component (A2-1) that can cause the curable component (A1) to undergo a polyaddition polymerization reaction with heat, an acid anhydride, a carboxylic acid, an amine, a phenol, a polyol, a hydrazide, or a polymercaptan may be used. Among others, it is preferable to use a carboxylic acid, an amine, a phenol, or a polyol from the viewpoint of adhesion to a pseudo wafer, preservation stability, moisture-resistance reliability, and the like.

As an example of an acid anhydride, methyltetrahydrophthalic anhydride, methylhexahydrophthalic anhydride, hexahydrophthalic anhydride, methylhimic anhydride, pyromellitic dianhydride, benzophenonetetracarboxylic dianhydride, 3,4-dimethyl-6-(2-methyl-1-propenyl)-1,2,3,6-tetrahydrophthali c anhydride, or 1-isopropyl-4-methyl-bicyclo[2.2.2]oct-5-ene-2,3-dicarboxylic anhydride may be used. These may be used singly, or in a mixture of two or more thereof.

For example, when the curable component (A1) is an epoxy compound, the content of an acid anhydride is determined so that the ratio of the number of curing functional groups (epoxy groups) to the number of carboxylic acids generated from acid anhydride groups (the number of curing functional groups in the curable component (A1) / the number of carboxylic acids) is preferably 0.2 to 20, and more preferably 0.4 to 16. By adjusting the content of an acid anhydride within the above-mentioned range, the curing reaction can effectively proceed. When the curable component (A1) is not an epoxy group, the content can be calculated in a similar manner, based on the ratio of the number of curing functional groups participating in the curing reaction to the number of carboxyl groups generated from acid anhydride groups (the number of curing functional groups in the curable component (A1) / the number of carboxylic acids).

As an example of a carboxylic acid, adipic acid, maleic acid, methyltetrahydrophthalic acid, methylhexahydrophthalic acid, hexahydrophthalic acid, methylhimic acid, pyromellitic acid, benzophenonetetracarboxylic acid, 3,4-dimethyl-6-(2-methyl-1-propenyl)-1,2,3,6-tetrahydrophthali c acid, 1-isopropyl-4-methyl-bicyclo[2.2.2]oct-5-ene-2,3-dicarboxylic acid, or a resin having a carboxyl group on a side chain may be used. These may be used singly, or in a mixture of two or more thereof.

When the curable component (A1) is an epoxy compound, the content of a carboxylic acid is determined so that the ratio of the number of curing functional groups (epoxy groups) to the number of carboxylic acids generated from acid anhydride groups (the number of curing functional groups in the curable component (A1) / the number of carboxyl groups)

is preferably 0.2 to 20, and more preferably 0.4 to 16. By adjusting the content of a carboxylic acid within the above-mentioned range, the curing reaction can effectively proceed. When the curable component (A1) is not an epoxy group, the amount can be calculated in a similar manner, based on the ratio of the number of curing functional groups participating in the curing reaction to the number of carboxyl groups (the number of curing functional groups in the curable component (A1) / the number of carboxyl groups).

As an example of amines, any compound having at least one primary or secondary amino group in a molecule may be used without restriction. However, an aromatic amine is preferably used from the viewpoint of preservation stability and heat resistance of cured products. As examples of an aromatic amine, diaminodiphenylmethane, diaminodiphenyl sulfone, diaminodiphenyl sulfide, metaxylene diamine, 3,3'-diethyl-4,4'-diaminodiphenylmethane, 3,3',5,5'-tetraethyl-4,4'-diaminodiphenylmethane, 4,4'-diaminodiphenyl sulfone, 4,4'-diaminodiphenyl sulfide, 2,2-bis-[4-(4-aminophenoxy)phenyl]-hexafluoropropane, 2,2-bis(4-aminophenyl)-hexafluoropropane, 2,4-diaminotoluene, 1,4-diaminobenzene, 1,3-diaminobenzene, diethyltoluene diamine, dimethyltoluene diamine, anilines, alkylated anilines, and N-alkylated anilines may be used. These may be used singly, or in a mixture of two or more thereof.

When the curable component (A1) is an epoxy compound, the content of an amine is determined so that the ratio of the number of curing functional groups (epoxy groups) to the number of active hydrogens (the number of epoxy groups / the number of active hydrogens) is preferably 0.2 to 20, and more preferably 0.4 to 16. By adjusting the content of an amine within the above-mentioned range, the curing reaction can effectively proceed. When the curable component (A1) is not an epoxy group, the content can be calculated in a similar manner, based on the ratio of the number of curing functional groups participating in the curing reaction to the number of active hydrogens (the number of curing functional groups in the curable component (A1) / the number of active hydrogens).

As examples of a phenol, a phenol novolak resin, an alkylphenol novolak resin, a bisphenol A novolak resin, a dicyclopentadiene phenol resin, a Xylok phenol resin, a terpene-modified phenol resin, a cresol/naphthol resin, a poly(vinyl phenol), a phenol/naphthol resin, a phenol resin containing an $\alpha$-naphthol skeleton, a triazine-containing cresol novolak resin, and various polyfunctional phenol resins may be used. These may be used singly, or in a mixture of two or more thereof.

When the curable component (A1) is an epoxy compound, the content of a phenol amine is determined so that the ratio of the number of curing functional groups (epoxy groups) to the number of phenolic hydroxyl groups (the number of epoxy groups / the number of phenolic hydroxyl groups) is preferably 0.2 to 20, and more preferably 0.4 to 16. By adjusting the content of a phenol within the above-mentioned range, the curing reaction can effectively proceed. When the curable component (A1) is not an epoxy group, the content can be calculated in a similar manner, based on the ratio of the number of curing functional groups participating in the curing reaction to the number of phenolic hydroxyl groups (the number of curing functional groups in the curable component (A1) / the number of phenolic hydroxyl groups).

As examples of a polyol, any polyol compound may be used without restriction as long as the compound has at least two hydroxyl groups per molecule. Examples of the polyol compound include a glycol having two alcoholic hydroxyl groups such as ethylene glycol, 1,2-propylene glycol, 1,3-butylene glycol, 1,4-butanediol, 1,6-hexanediol, diethylene glycol, dipropylene glycol, carbonatediol, neopentyl glycol, alkylene oxide adduct of a bisphenol, or alkylene oxide adduct of a hydrogenated bisphenol; a polyether diol such as polyethylene glycol, polypropylene glycol, or poly tetramethylene glycol; a polyester diol such as polyethylene adipate, polypropylene adipate, polybutylene adipate, polytetramethylene adipate, polypentamethylene adipate, polyhexamethylene adipate, or polycaprolactone diol; a polyhydric alcohol having three or more alcoholic hydroxyl groups such as trimethylolethane, trimethylolpropane, glycerin, or pentaerythritol; and a polycarbonate diol. These may be used singly, or in a mixture of two or more thereof.

When the curable component (A1) is an isocyanate compound, the content of a polyol is determined so that the ratio of the number of curing functional groups (isocyanate groups) to the number of hydroxyl groups (the number of isocyanate groups / the number of hydroxyl groups) is preferably 0.2 to 20, and more preferably 0.4 to 16. By adjusting the content of a polyol within the above-mentioned range, the curing reaction can effectively proceed. When the curable component (A1) is not an isocyanate group, the content can be calculated in a similar manner, based on the ratio of the number of curing functional groups participating in the curing reaction to the number of hydroxyl groups (the number of curing functional groups in the curable component (A1) / the number of hydroxyl groups).

As other examples of the curing agent component (A2-1) that can cause the curable component (A1) to undergo polymerization through a polyaddition polymerization reaction with heat, a cyanate ester resin or an active ester resin may be used. The cyanate ester resin is a compound having two or more cyanate ester groups (-OCN) in a molecule. Any of conventionally known cyanate ester resins may be used. Examples of the cyanate ester resin include a phenol novolak cyanate ester resin, an alkylphenol novolak cyanate ester resin, a dicyclopentadiene cyanate ester resin, a bisphenol A cyanate ester resin, a bisphenol F cyanate ester resin, and a bisphenol S cyanate ester resin. Further, it may be a prepolymer partially cyclized to form triazine.

The active ester resin is a resin having two or more active ester groups in a molecule. An active ester resin may be generally obtained by a condensation reaction of a carboxylic acid compound and a hydroxy compound. Among them, an active ester compound obtained by using a phenol compound or a naphthol compound as a hydroxy compound is

preferable. Examples of the phenol compound or naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, $\alpha$-naphthol, $\beta$-naphthol, 1,5-dihydroxynaphthalene, 1,6-dihydroxy naphthalene, 2,6-dihydroxy naphthalene, dihydroxybenzophenone, trihydroxybenzophenone, tetrahydroxybenzophenone, phloroglucin, benzenetriol, dicyclopentadienyl diphenol, and phenol novolak.

When used as the curing agent component (A2-1) that can cause the curable component (A1) to undergo polymerization through a polyaddition polymerization reaction with heat, a carboxylic acid, an acid anhydride, an amine, a phenol, a cyanate ester resin, or an active ester resin may be used in combination with a curing accelerator. Any of the above-described imidazoles may be used as the curing accelerator. Other examples of the curing accelerator include a guanamine, such as acetoguanamine and benzoguanamine; an organic acid salt and/or epoxy adduct of a polyamine, such as diaminodiphenylmethane, m-phenylenediamine, m-xylenediamine, diaminodiphenylsulfone, dicyandiamide, urea, urea derivatives, melamine, and a polybasic hydrazide; an amine complex of boron trifluoride; a triazine derivative, such as ethyldiamino-s-triazine, 2,4-diamino-s-triazine, and 2,4-diamino-6-xylyl-s-triazine; an organic phosphine, such as tributylphosphine, triphenylphosphine, and tris-2-cyanoethylphosphine; a phosphonium salt, such as tri-n-butyl(2,5-dihydroxyphenyl)phosphonium bromide, and hexadecyltributylphosphonium chloride; a quaternary ammonium salt, such as benzyltrimethylammonium chloride, and phenyltributylammonium chloride; and the polybasic acid anhydride. These may be used singly, or in a mixture of two or more thereof.

Although the curing accelerator component is not indispensable, particularly when it is desired to accelerate the curing reaction, it may be added preferably in a range of 0.01 to 20 parts by mass with respect to 100 parts by mass of the above-described curing agent component (A2-1) that can cause the curable component (A1) to undergo polymerization through a polyaddition polymerization reaction with heat. When a metal catalyst is used as the curing accelerator component, the content thereof in terms of metal is preferably 10 to 550 ppm with respect to 100 parts by mass of the curable component, and more preferably 25 to 200 ppm.

As an example of the curing agent component (A2-2) that is not according to the claimed invention and can cause the curable component (A1) to undergo ionic polymerization, which is cationic polymerization in particular, with active energy rays, a cationic light curing agent may be used. Specific examples of the cationic light curing agent include diphenyliodonium tetrafluoroborate, triphenylsulfonium hexafluoroantimonate, and 2,4,6-triphenylthiopyrylium hexafluorophosphate, and commercially supplied products including sulfonium salt-based cationic photopolymerization initiators such as Optomer SP-170 and SP-152 manufactured by ADEKA Corporation and CPI-100P, CPI-101A, CPI-200K, and CPI-210S manufactured by San-Apro Ltd., as well as including IRGACURE® 261 manufactured by BASF Japan Ltd. Among others, SP-152, CPI-100P, and CPI-200K are preferable. These cationic photopolymerization initiator may be used singly, or in a mixture of two or more thereof.

When a cationic light curing agent is used as the curing agent component (A2-2) that is not according to the claimed invention and can cause the curable component (A1) to undergo cationic polymerization with active energy rays, the content of the light curing agent is preferably 1 to 25 parts by mass, and more preferably 5 to 20 parts by mass, with respect to 100 parts by mass of the thermally curable component (A1).

As the light curing agent component (A2-2) that is not according to the claimed invention, an anionic light curing agent component may also be used. Specific examples of the anionic light curing agent component include a compound that generates amines when irradiated with ultraviolet rays, and more specifically, such examples may include 1,10-diaminodecane, 4,4'-trimethylenedipiperidine, a carbamate and its derivatives, a cobalt-amine complex, an aminooxy imino, and an ammonium borate.

When an anionic light curing agent is used as the light curing agent component (A2-2) that is not according to the claimed invention, the content of the light curing agent is preferably 1 to 25 parts by mass, more preferably 5 to 20 parts by mass, and further preferably 10 to 20 parts by mass with respect to 100 parts by mass of the thermally curable component (A1).

<Curable Component (B1)>

The curable resin composition according to the present invention includes a curable component (B1) that contracts in volume through a curing reaction different from the curing reaction that the above-described curable component (A1) undergoes. Assuming that the material used as the curable component (A1) can be cured through, for example, an ionic ring-opening polymerization reaction or a polyaddition polymerization reaction as described above, the curable component (B1) may be any one selected from known materials other than the materials that can be cured through an ionic ring-opening polymerization reaction or a polyaddition polymerization reaction. For example, a curable component that can be cured through a radical addition polymerization reaction may be preferably used as the curable component (B1). Radical addition polymerization, as used herein, means a reaction in which a radical initiates polymerization and then an unsaturated compound having a double or triple bond is added thereto to be formed into a polymer. The curable component that can be cured through such radical addition polymerization reaction is preferably a compound

having at least one ethylenic unsaturated group in a molecule.

When the curable resin composition includes a curable component (A1) that can be cured through an ionic ring-opening polymerization reaction or a polyaddition polymerization reaction as described above and a curable component (B1) that can be cured through a radical addition polymerization reaction, the curable components (A1) and (B1) can be separately cured during curing of the curable resin composition. Therefore, by using the curable resin composition to form a warpage correction layer, curing reactions occurring in the individual curable components can be controlled in accordance with the amount of warpage of the pseudo wafer (that is, the stress acting on the FO-WLP through volume contraction of the insulation layer), and thus the warpage correction layer can generate a contraction stress comparable to the warping stress present in the pseudo wafer. As a result, less warped FO-WLPs can be obtained even when the FO-WLPs having different insulation films in material, thickness, or pattern are produced. For example, curing reactions can be independently controlled by causing the curable component (A1) that can be cured through an ionic ring-opening polymerization reaction or a polyaddition polymerization reaction to be cured with heat, and by causing the curable component (B1) that can be cured through a radical addition polymerization reaction to be cured with active energy rays.

Specific examples of the component having at least one ethylenic unsaturated group in a molecule and having radical addition polymerization reactivity include conventionally known polyester (meth)acrylates, polyether (meth) acrylates, urethane (meth)acrylates, carbonate (meth)acrylates, and epoxy (meth)acrylates. Specifically, the examples include at least any one of: a hydroxyalkyl acrylate such as 2-hydroxyethyl acrylate or 2-hydroxypropyl acrylate; a glycol diacrylate such as ethylene glycol, methoxytetraethylene glycol, polyethylene glycol, or propylene glycol; an acrylamide such as N,N-dimethylacrylamide, N-methylolacrylamide, or N,N-dimethylaminopropylacryl amide; an aminoalkyl acrylate such as N,N-dimethylaminoethyl acrylate or N,N-dimethylaminopropyl acrylate; a polyhydric alcohol such as hexanediol, trimethylolpropane, pentaerythritol, dipentaerythritol, or tris-hydroxyethyl isocyanurate, or a polyacrylate such as an ethylene oxide adduct thereof, a propylene oxide adduct thereof, or a ε-caprolactone adduct thereof; a polyacrylate such as phenoxy acrylate, bisphenol-A diacrylate, an ethylene oxide adduct or propylene oxide adduct of these phenols; a polyacrylate of glycidyl ethers such as glycerin diglycidyl ether, glycerin triglycidyl ether, trimethylolpropane triglycidyl ether, or triglycidyl isocyanurate; an acrylate not limited to the foregoing but is obtained by directly acrylating, or urethane-acrylating via diisocyanate, a polyol such as polyetherpolyol, polycarbonatediol, hydroxyl-terminated polybutadiene, or polyesterpolyol, and a melamine acrylate; and each of methacrylates corresponding to the foregoing acrylates. These may be used singly, or in a mixture of two or more thereof.

As other examples of the curable component (B-1) that can be cured through a radical addition polymerization reaction, compounds including those described in (1) to (11) below may be used:

(1) an unsaturated group-containing polymer obtained by reacting a compound having a plurality of phenolic hydroxyl groups in a molecule with alkylene oxide, and then reacting the resulting reaction product with a mono carboxylic acid containing an unsaturated group, and then reacting the resulting reaction product with a polybasic acid anhydride;
(2) an acryl-containing polymer obtained by reacting a difunctional or polyfunctional epoxy resin with (meth)acrylic acid and adding a dibasic acid anhydride to a hydroxyl group present on a side chain;
(3) an acryl-containing polymer obtained by reacting a polyfunctional epoxy resin, which is obtained by epoxidizing a hydroxyl group of a difunctional epoxy resin with epichlorohydrin, with (meth)acrylic acid and adding a dibasic acid anhydride to a generated hydroxyl group;
(4) an unsaturated group-containing polymer obtained by reacting a compound having a plurality of phenolic hydroxyl groups in a molecule with a cyclic carbonate compound, and then reacting the resulting reaction product with a mono carboxylic acid containing an unsaturated group, and then reacting the resulting reaction product with a polybasic acid anhydride;
(5) an acryl-containing urethane resin obtained through a polyaddition reaction of a diisocyanate with (meth)acrylate of a difunctional epoxy resin or a partial acid-anhydride modification thereof, a carboxyl group-containing dialcohol compound, and a diol compound;
(6) an unsaturated group-containing polymer obtained through copolymerization of an unsaturated carboxylic acid and an unsaturated group-containing compound;
(7) an acryl-containing, terminal-(meth)acrylated urethane resin obtained by adding a compound having one hydroxyl group and at least one (meth)acryloyl group in a molecule during synthesis of a resin through a polyaddition reaction of a diisocyanate with a carboxyl group-containing dialcohol compound and a diol compound;
(8) an acryl-containing, terminal-(meth)acrylated urethane resin obtained by adding a compound having one isocyanate group and at least one (meth)acryloyl group in a molecule during synthesis of a resin through a polyaddition reaction of a diisocyanate with a carboxyl group-containing dialcohol compound and a diol compound;
(9) an acryl-containing, terminal-(meth)acrylated urethane resin obtained by adding a compound having one hydroxyl group and at least one (meth)acryloyl group in a molecule during synthesis of the resin described in (5) above;
(10) an acryl-containing, terminal-(meth)acrylated urethane resin obtained by adding a compound having one isocyanate group and at least one (meth)acryloyl group in a molecule during synthesis of the resin described in

(5) above; and

(11) an acryl-containing polymer obtained by further adding a compound having one epoxy resin and at least one (meth)acryloyl group in a molecule to any of the resins described in (1) to (10) above.

These may be used singly, or in combination of two or more thereof, or in combination with a monomer having at least one ethylenic unsaturated group in a molecule as described above.

The curable resin composition according to the present invention preferably includes a curing agent component (B2) capable of curing the curable component (B1). The curing agent component (B2) is a curing agent component (B2-2) that can cause the curable component (B1) to undergo radical polymerization with active energy rays. Also disclosed is a curing agent component (B2-1) that is not according to the claimed invention and can cause the curable component (B1) to undergo radical polymerization with heat can cause the curable component (B1) to undergo radical polymerization with heat. The curing agent component B2-2 is appropriately selected depending on the combination with a curing agent component (A2) capable of curing the curable component (A1) described above. For example, when the curable component (B1) is intended to undergo polymerization, a curing agent component can be selected so that the curable component (A1) is prevented from developing a curing reaction in conjunction with the curing reaction of the curable component (B1).

Examples of the heat curing agent component (B2), or more specifically, the curing agent component (B2-1) that is not according to the claimed invention and can cause the curable component (B1) to undergo radical polymerization with heat, include: a ketone peroxide such as methyl ethyl ketone peroxide, methyl isobutyl ketone peroxide, acetylacetone peroxide, cyclohexanone peroxide, and methylcyclohexanone peroxide; a hydroperoxide such as 1,1,3,3-tetramethylbutyl hydroperoxide, cumene hydroperoxide, and t-butyl hydroperoxide; a diacyl peroxide such as diisobutyryl peroxide, bis-3,5,5-trimethylhexanoyl peroxide, lauroyl peroxide, benzoyl peroxide, and m-toluyl benzoyl peroxide; a dialkyl peroxide such as dicumyl peroxide, 2,5-dimethyl-2,5-di(t-butylperoxy)hexane, 1,3-bis(t-butylperoxy isopropyl)hexane, t-butyl cumyl peroxide, di-t-butyl peroxide, and 2,5-dimethyl-2,5-di(t-butylperoxy)hexene; a peroxy ketal such as 1,1-di-(t-butylperoxy-3,5,5-trimethyl)cyclohexane, 1,1-di-t-butylperoxy cyclohexane, and 2,2-di(t-butylperoxy)butane; an alkyl perester such as t-hexyl peroxypivalate, t-butyl peroxypivalate, 1,1,3,3-tetramethylbutyl peroxy-2-ethylhexanoate, t-amylperoxy-2-ethylhexanoate, t-butylperoxy-2-ethylhexanoate, t-butylperoxy isobutyrate, di-t-butylperoxy hexahydroterephthalate, 1,1,3,3-tetramethylbutylperoxy-3,5,5-trimethylhexanate, t-amylperoxy-3,5,5-trimethylhexanoate, t-butylperoxy-3,5,5-trimethylhexanoate, t-butylperoxy acetate, t-butylperoxy benzoate, and dibutylperoxy trimethyladipate; a peroxycarbonate such as 1,1,3,3-tetramethylbutylperoxy neodicarbonate, $\alpha$-cumylperoxy neodicarbonate, t-butylperoxy neodicarbonate, di-3-methoxybutylperoxy dicarbonate, di-2-ethylhexylperoxy dicarbonate, bis(1,1-butylcyclohexaoxy dicarbonate), diisopropyloxy dicarbonate, t-amylperoxyisopropyl carbonate, t-butylperoxyisopropyl carbonate, t-butylperoxy-2-ethylhexyl carbonate, and 1,6-bis(t-butylperoxycarboxy)hexane; 1,1-bis(t-hexylperoxy)cyclohexane; and (4-t-butylcyclohexyl)peroxy dicarbonate. These may be used singly, or in a mixture of two or more thereof.

The content of the curing agent component (B2-1) that is not according to the claimed invention and can cause the curable component (B1) to undergo a radical addition polymerization reaction with heat is preferably 1 to 25 parts by mass, more preferably 5 to 20 parts by mass, and further preferably 10 to 20 parts by mass with respect to 100 parts by mass of the curable component (B1).

Examples of the curing agent component (B2-2) that can cause the curable component (B1) to undergo a radical addition polymerization reaction with active energy rays include: an acylphosphine oxide such as bis-(2,6-dichlorobenzoyl)phenylphosphine oxide, bis-(2,6-dichlorobenzoyl)-2,5-dimethylphenylphosphine oxide, bis-(2,6-dichlorobenzoyl)-4-propylphenylphosphine oxide, bis-(2,6-dichlorobenzoyl)-1-naphthylphosphine oxide, bis-(2,6-dimethoxybenzoyl)phenylphosphine oxide, bis-(2,6-dimethoxybenzoyl)-2,4,4-trimethylpentylphosphine oxide, bis-(2,6-dimethoxybenzoyl)-2,5-dimethylphenylphosphine oxide, bis-(2,4,6-trimethylbenzoyl)-phenylphosphine oxide (IRGACURE 819 manufactured by BASF Japan Ltd.), 2,6-dimethoxybenzoyl diphenylphosphine oxide, 2,6-dichlorobenzoyl diphenylphosphine oxide, 2,4,6-trimethylbenzoyl phenylphosphinic acid methyl ester, 2-methylbenzoyl diphenylphosphine oxide, pivaloyl phenylphosphinic acid isopropyl ester, and 2,4,6-trimethylbenzoyl diphenylphosphine oxide (IRGACURE TPO manufactured by BASF Japan Ltd.); a hydroxy acetophenone such as 1-hydroxy-cyclohexyl phenyl ketone, 1-[4-(2-hydroxyethoxy)-phenyl]-2-hydroxy-2-methyl-1-propan-1-one, 2-hydroxy-1-{4-[4-(2-hydroxy-2-methyl-propionyl)-benzyl]phen yl}-2-methyl-propan-1-one, and 2-hydroxy-2-methyl-1-phenylpropan-1-one; a benzoin such as benzoin, benzyl, benzoin methyl ether, benzoin ethyl ether, benzoin n-propyl ether, benzoin isopropyl ether, and benzoin n-butyl ether; a benzoin alkyl ether; a benzophenone such as benzophenone, p-methylbenzophenone, Michler's ketone, methylbenzophenone, 4,4'-dichlorobenzophenone, and 4,4'-bis diethylamino benzophenone; an acetophenone such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, 2-methyl-1-[4-methylthio)phenyl]-2-morpholino-1-propanone, 2-benzyl-2-dimethylamino-1-(4-morpholinophenyl)-butanone-1, 2-(dimethylamino)-2-[(4-methylphenyl)methyl)-1-[4-(4-morpho linyl)phenyl]-1-butanone, and N,N-dimethylaminoacetophenone; a thioxanthone such as thioxanthone, 2-ethylthioxanthone, 2-isopropylthioxanthone, 2,4-dimethylthioxanthone, 2,4-diethylthioxanthone, 2-chlorothioxanthone, and 2,4-diisopropylthioxanthone;

an anthraquinone such as anthraquinone, chloroanthraquinone, 2-methylanthraquinone, 2-ethylanthraquinone, 2-tert-butylanthraquinone, 1-chloroanthraquinone, 2-amylanthraquinone, and 2-aminoanthraquinone; a ketal such as acetophenone dimethyl ketal and benzil dimethylketal; a benzoic ester such as ethyl 4-dimethylaminobenzoate, 2-(dimethylamino)ethyl benzoate, and p-dimethylbenzoic acid ethyl ester; an oxime ester such as 1,2-octanedione, 1-[4-(phenylthio)-,2-(O-benzoyloxime)], Ethanone, 1-[9-ethyl-6-(2-methylbenzoyl)-9H-carbazol-3-yl]-,1-(O-acetylo xime); and a titanocene such as bis(η5-2,4-cyclopentadien-1-yl)-bis(2,6-difluoro-3-(1H-pyrrol-1-yl)phenyl)titanium and bis(cyclopentadienyl)-bis[2,6-difluoro-3-(2-(1-pyrr-1-yl)ethyl) phenyl]titanium; as well as including phenyl disulfide 2-nitrofluorene, butyroin, anisoin ethyl ether, azobisisobutyronitrile, and tetramethylthiuram disulfide. These may be used singly, or in a mixture of two or more thereof.

Among the above-listed curing agent components (B2-2), it is preferable to use at least one photopolymerization initiator selected from the group consisting of an oxime ester (hereinafter called an "oxime ester-based photopolymerization initiator"), an α-aminoacetophenone (hereinafter called an "α-aminoacetophenone-based photopolymerization initiator), which is one of acetophenones, and an acylphosphine oxide (hereinafter called an "acylphosphine oxide-based photopolymerization initiator").

Examples of the oxime ester-based photopolymerization initiator include CGI-325, IRGACURE OXE01, and IRGACURE OXE02 manufactured by BASF Japan Ltd. and N-1919 manufactured by ADEKA Corporation, all of which are commercially supplied. In addition, a photopolymerization initiator having two oxime ester groups in a molecule may be suitably used. A specific example thereof may be an oxime ester compound having a carbazole structure as expressed by the following general formula:

[Chem. 1]

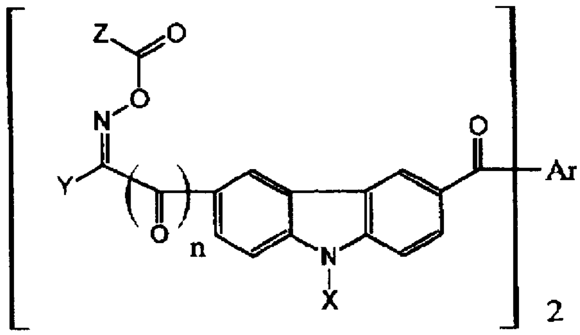

wherein X represents a hydrogen atom, $C_1$-$C_{17}$ alkyl, $C_1$-$C_8$ alkoxy, phenyl, phenyl (which is substituted with $C_1$-$C_{17}$ alkyl, $C_1$-$C_8$ alkoxy, amino, or alkylamino or dialkylamino having $C_1$-$C_8$ alkyl), or naphthyl (which is substituted with $C_1$-$C_{17}$ alkyl, $C_1$-$C_8$ alkoxy, amino, or alkylamino or dialkylamino having $C_1$-$C_8$ alkyl); Y and Z each represent a hydrogen atom, $C_1$-$C_{17}$ alkyl, $C_1$-$C_8$ alkoxy, halogen, phenyl, phenyl (which is substituted with $C_1$-$C_{17}$ alkyl, $C_1$-$C_8$ alkoxy, amino, or alkylamino or dialkylamino having $C_1$-$C_8$ alkyl), naphthyl (which is substituted with $C_1$-$C_{17}$ alkyl, $C_1$-$C_8$ alkoxy, amino, or alkylamino or dialkylamino having $C_1$-$C_8$ alkyl), anthryl, pyridyl, benzofuryl, or benzothienyl; Ar represents $C_1$-$C_{10}$ alkylene, vinylene, phenylene, biphenylene, pyridylene, naphthylene, thiophene, anthrylene, thienylene, furylene, 2,5-pyrrole-diyl, 4,4'-stilbene-diyl, or 4,2'-styrene-diyl; and n is an integer of 0 or 1.

In a particularly preferable oxime ester compound having a carbazole structure as expressed by the above general formula, each of X and Y is methyl or ethyl, Z is methyl or phenyl, n is 0, and Ar is phenylene, naphthylene, thiophene, or thienylene.

The content of an oxime ester-based photopolymerization initiator is preferably 0.01 to 5 parts by mass with respect to 100 parts by mass of a polyether compound containing an ethylenic unsaturated group in a molecule.

Specific examples of the α-aminoacetophenone-based photopolymerization initiator include 2-methyl-1-[4-(methylthio)phenyl]-2-morpholinopropanone-1,2-benzyl-2-di methylamino-1-(4-morpholinophenyl)-butan-1-one, 2-(dimethylamino)-2-[(4-methylphenyl)methyl]-1-[4-(4-morpho linyl)phenyl]-1-butanone, and N,N-dimethylaminoacetophenone. Examples of the initiator commercially supplied include IRGACURE 907, IRGACURE 369, and IRGACURE 379 manufactured by BASF Japan Ltd.

Examples of the acylphosphine oxide-based photopolymerization initiator include the above-listed compounds. Examples of the initiator commercially supplied include IRGACURE TPO and IRGACURE 819 manufactured by BASF Japan Ltd.

The content of a photopolymerization initiator other than oxime ester-based photopolymerization initiators is preferably 0.1 to 30 parts by mass with respect to 100 parts by mass of the polyether compound containing an ethylenic unsaturated group in a molecule. When the content is 0.1 or more parts by mass, the resin composition has better

photocurability, and the coating is less likely to be peeled off and has better properties including higher chemical resistance. When the content is 30 or less parts by mass, the effect of reducing outgassing is exerted, the coating absorbs light well on its surface, and the deep curing characteristics are less impaired. More preferably, the content is 0.5 to 15 parts by mass.

When used as the curing agent component (B2-2) that can cause the curable component (B1) to undergo a radical addition polymerization reaction with active energy rays, an oxime ester-based photopolymerization initiator provides a satisfactory sensitivity even with a small amount of the initiator and, furthermore, reduces contamination of equipment such as an oven because of less volatilization of the photopolymerization initiator during thermal curing performed when a thermally curable component is contained and during a post-heating process when a package is mounted.

On the other hand, an acylphosphine oxide-based photopolymerization initiator provides better deep curing characteristics during photoreaction, and thus a better opening shape in terms of resolution can be obtained.

Although either of an oxime ester-based photopolymerization initiator and an acylphosphine oxide-based photopolymerization initiator is effective, from the viewpoint of the line shape of resist, balanced openings, and photocurability as described above, it is more preferable to use both the oxime ester-based photopolymerization initiator and the acylphosphine oxide-based photopolymerization initiator together.

As the curing agent component (B2-2) that can cause the curable component (B1) to undergo a radical addition polymerization reaction with active energy rays, commercially supplied products may also be used. For example, IRGACURE 389 and IRGACURE 784 manufactured by BASF Japan Ltd. may be suitably used.

The content of the curing agent component (B2-2) that can cause the curable component (B1) to undergo a radical addition polymerization reaction with active energy rays is preferably 1 to 25 parts by mass, more preferably 5 to 20 parts by mass, and further preferably 10 to 20 parts by mass with respect to 100 parts by mass of the curable component (B1).

In the present invention, when a light curing component (B2-2) is included as the curing agent component, a photoinitiation aid or a sensitizer may be included in the curable resin composition. Examples of either of the photoinitiation aid and the sensitizer include a benzoin compound, an acetophenone compound, an anthraquinone compound, a thioxanthone compound, a ketal compound, a benzophenone compound, a tertiary amine compound, and a xanthone compound. A photoinitiation aid and a sensitizer may be used singly or in a mixture of two or more thereof. Among the above-listed compounds, a thioxanthone compound and a tertiary amine compound are preferable. In particular, a thioxanthone compound is preferably included in view of deep curing characteristics of the resin composition. Among others, it is preferable to include any of thioxanthone compounds including, for example, 2,4-dimethylthioxanthone, 2,4-diethylthioxanthone, 2-chlorothioxanthone, and 2,4-diisopropylthioxanthone.

In the present invention, the curable composition comprises the following combination of the above-described curable components and curing agent components:

1) Combination of the curable component (A1), the heat curing agent component (A2-1) as the curing agent component (A2) capable of curing the curable component (A1), the curable component (B1), and the light curing agent component (B2-2) as the curing agent component (B2) capable of curing the curable component (B1).

In the combination (1) above, the curable component (A1) after cured has a volume contraction ratio A (%)falling within a range of $0 < A \leq 7$, while the curable component (B1) after cured has a volume contraction ratio B (%)falling within a range of $5 \leq B \leq 30$. When a warpage correction layer is formed by applying a coating to the pseudo wafer for a FO-WLP, the coating being made of the curable resin composition that contains two different curable components having such volume contraction ratios, and by causing a curing reaction with heat and active energy rays so as to cure the curable resin composition, the warpage correction layer sticks to the pseudo wafer with greater adhesion and can correct warpage of the pseudo wafer.

The volume contraction ratio resulting from a curing reaction in the present invention is calculated by measuring densities of the curable component measured before and after curing and in accordance with the following equation.

Volume contraction ratio (%) = (1 - (density of curable component before curing)/(density of curable component after curing) $\times$ 100

For example, assuming that the monomer solution has a density of 1.0 g/cm$^3$ before curing and the cured product (polymer) obtained by curing the monomer has a density of 1.2 g/cm$^3$, the volume contraction ratio (%) is about 17%. When the curable component is in a liquid state, the density can be measured based on the mass of the component obtained by taking a certain volume of the component under an atmosphere at 25°C, for example. When the curable component is a solid or is a cured product, the density can be measured by using the fluid displacement method (Archimedes method).

More specifically, the density ($\rho$) can be calculated by using, for example, XS205 Analytical Balance and the density measurement kit "Solid and Liquid Density Determination" manufactured by Mettler-Toledo AG, as well as using distilled water as the displaced fluid, and in accordance with the following equation:

$$\rho = (\alpha \times \rho_0) / (\alpha - \beta)$$

(wherein $\rho$ represents the density of a solid, $\alpha$ represents the mass of the solid in atmosphere, $\beta$ represents the mass of the solid in a displaced fluid, and $\rho_0$ represents the density of distilled water at a measurement temperature.)

The volume contraction ratio C (%) of the whole cured curable resin composition including the curable components (A1) and (B1) is preferably in a range of $0 < C \leq 20$, and more preferably in a range of $0 < C \leq 17$. As with the foregoing, the volume contraction ratio of the whole cured curable resin composition can be calculated in accordance with the following equation.

Volume contraction ratio (%) = (1 - (density of the whole curable resin composition before curing)/(density of the whole curable resin composition after curing) $\times$ 100

In the present invention, the content ratio based on mass between the curable components (A1) and (B1) included in the curable resin composition preferably falls within a range of $0.05 \leq (A1)/(B1) \leq 20$, and more preferably a range of $0.07 \leq (A1)/(B1) \leq 15$. When the curable components (A1) and (B1) are contained in the aforementioned content ratio, curing reactions on these two curable components uniformly proceed. As a result, the effect of much more excellent warpage correction can be obtained.

If intended to be formed into a film (or sheet), the curable resin composition according to the present invention may contain a filmability imparting polymer component (C1) that makes it easy to maintain the shape of a film (or sheet). Examples of such filmability imparting polymer component (C1) include a thermoplastic polyhydroxy polyether resin, a phenoxy resin which is a condensation product of epichlorohydrin and various bifunctional phenol compounds, or a phenoxy resin obtained by esterifying a hydroxyl group in the hydroxyether moiety present in the skeleton thereof using various acid anhydrides or acid chlorides, a poly(vinyl acetal) resin, a polyamide resin, a polyamide imide resin, and a block copolymer. These polymers may be used singly, or in a mixture of two or more thereof. In order to maintain the shape of a film (or sheet), the weight average molecular weight (Mw) of the polymers is ordinarily $2 \times 10^4$ or higher, and preferably $2 \times 10^4$ to $3 \times 10^6$.

The value of a weight average molecular weight (Mw) can be measured herein by the gel permeation chromatography (GPC) method (polystyrene standard) using the following measuring apparatus and measurement conditions.

Measuring apparatus: "Waters 2695", manufactured by Waters Corp.
Detector: RI (differential refractometer), "Waters 2414", manufactured by Waters Corp.
Column: "HSPgel Column HR MB-L, 3 μm, 6 mm × 150 mm" manufactured by Waters Corp. × 2 + "HSPgel Column, HR 1, 3 μm, 6 mm × 150 mm" manufactured by Waters Corp. × 2
Measurement conditions:

Column temperature: 40°C
RI detector setting temperature: 35°C
Developing solvent: tetrahydrofuran
Flow rate: 0.5 mL/min
Sample volume: 10 μL
Sample concentration: 0.7 wt-%

The poly(vinyl acetal) resin is obtained, for example, by acetalizing a poly(vinyl alcohol) resin with aldehyde. There is no particular restriction on the aldehyde, and examples thereof include formaldehyde, acetaldehyde, propionaldehyde, and butyraldehyde.

Specific examples of the phenoxy resin include FX 280 and FX 293 manufactured by Tohto Chemical Industry Co., Ltd., and YX 8100, YL 6954, and YL 6974 manufactured by Mitsubishi Chemical Corporation.

Specific examples of a poly(vinyl acetal) resin include S-LEC KS series manufactured by Sekisui Chemical Co., Ltd. Specific examples of a polyamide resin include KS 5000 series manufactured by Hitachi Chemical Co., Ltd. and BP series manufactured by Nippon Kayaku Co., Ltd.

Specific examples of a polyamide-imide resin include KS 9000 series manufactured by Hitachi Chemical Co., Ltd.

In a case where the thermoplastic polyhydroxy polyether resin has a fluorene skeleton which develops a high glass transition point and superior heat resistance, the resin maintains a low coefficient of thermal expansion of a semi-solid or solid epoxy resin, while securing a high glass transition point, so that a cured film obtained therefrom has a low coefficient of thermal expansion and a high glass transition point in a well-balanced manner. In addition, since the thermoplastic polyhydroxypolyether resin has a hydroxyl group, it exhibits good adhesion to a pseudo wafer.

The filmability imparting polymer component (C1) may be one obtained by block copolymerization of monomers constituting the above-described components. A block copolymer means a copolymer having a molecular structure in which two or more kinds of polymers having different properties are linked by covalent bonds to form a long chain. As the block copolymer, an X-Y-X type, or X-Y-X' type block copolymer is preferable. Among the X-Y-X type and X-Y-X' type block copolymers, the one, in which the central Y is a soft block with a low glass transition temperature (Tg), and either of the outside X and X' is constituted with a polymer unit that is a hard block with a glass transition temperature (Tg) higher than the central Y block, is preferable. A glass transition temperature (Tg) is measured by differential scanning calorimetry (DSC).

Among the X-Y-X type and X-Y-X' type block copolymers, a block copolymer in which X or X' is constituted with a polymer unit having a Tg of 50°C or higher, and Y is constituted with a polymer unit having a glass transition temperature (Tg) not higher than the Tg of X or X' is more preferable. Among the X-Y-X type and X-Y-X' type block copolymers, the one, in which X or X' is highly compatible with the curable component (A1) or the curable component (B1), is preferable, and the one, in which Y is scarcely compatible with the curable component (A1) or the curable component (B1), is preferable. It is conceivable that a specific structure may easily appear in the matrix, by forming a block copolymer in which the outside blocks are compatible with a matrix (curable component), and the central block is incompatible with a matrix (curable component)

Among the various filmability imparting polymer components (C1) listed above, the phenoxy resin, the poly(vinyl acetal) resin, the thermoplastic polyhydroxy polyether resin having a fluorene skeleton, and the block copolymer are preferable.

In the case where a filmability imparting polymer component (C1) is added to the curable resin composition of the present invention, there is no particular restriction on the proportion of a filmability imparting polymer component (C1) occupying in all the components constituting the curable resin composition, and it is preferably 2 to 40 parts by mass with respect to the total of all the components as 100 parts by mass, and more preferably 5 to 35 parts by mass.

The curable resin composition according to the present invention may contain an inorganic filler component (D). An inorganic filler component (D) contained therein facilitates cutting for, for example, dicing a FO-WLP. Further, by applying laser marking to the protective coat, the inorganic filler component (D) is exposed at the portion scraped off by the laser beam to scatter reflected light, so that the color turns close to white. By this means, when a FO-WLP warpage correction material contains a colorant component (E) described below, an effect may be obtained that a strong contrast between the laser marking portion and the other portion may be obtained, and the marking (print) becomes clear.

As an inorganic filler component (D), any conventionally known materials may be used without limitation, and examples thereof include a powder, such as silica, alumina, talc, aluminum hydroxide, calcium carbonate, Neuburg siliceous earth, glass powder, clay, magnesium carbonate, natural mica, synthetic mica, barium sulfate, barium titanate, hydrotalcite, mineral wool, aluminium silicate, calcium silicate, zinc oxide, titanium oxide, iron oxide, silicon carbide, and boron nitride; and spherical beads formed therefrom; single crystal fibers; and glass fibers. These may be used singly, or in a mixture of two or more thereof. Among the above, silica, alumina, and titanium oxide are preferably used for the purpose of controlling the relative permittivity in a film.

An inorganic filler component (D) having an average particle diameter of preferably 0.01 to 15 $\mu$m, more preferably 0.02 to 12 $\mu$m, and especially preferably 0.03 to 10 $\mu$m may be used. An average particle size is herein a number average particle diameter determined by measuring major axis diameters of 20 particles of an inorganic filler (C) randomly selected under an electron microscope, and calculating the arithmetic average.

The content of the inorganic filler component (D) is preferably 10 to 400 parts by mass, more preferably 20 to 350 parts by mass, and especially preferably 30 to 300 parts by mass with respect to 100 parts by mass of the total sum of the curable components (A1) and (B1), the curing agent components (A2) and (B2), and the reactive filmability imparting polymer component (C1) and the reactive filmability imparting polymer component (C2), as included in the curable resin composition.

The curable resin composition according to the present invention may contain a colorant component (E). When the colorant component (E) is contained, and a semiconductor chip provided with the curable resin composition is incorporated in an apparatus, it becomes possible to prevent malfunction of the semiconductor device due to infrared rays, etc. emitted from nearby devices. Further, when a marking is engraved in the curable composition by a means such as laser marking, a letter or a symbol may be recognized easily. In other words, with respect to a semiconductor chip on which a curable resin composition is formed, when a product number or the like is printed on the surface of the protective coat usually by a laser marking method (by a printing method by which the surface of the protective coat is scraped off in a pattern by a laser beam), a high enough contrast difference between the part scraped off by the laser beam and the part not

scraped off of the protective coat is obtained so as to enhance recognizability owing to the existence of a colorant in the curable resin composition.

As the colorant component (E), organic or inorganic pigments and dyes may be used singly or in combination of two or more thereof. Among others, a black pigment is preferable in view of shielding electromagnetic waves and infrared rays. As a black pigment, carbon black, perylene black, perylene black, iron oxide, aniline black, activated carbon, etc. are used, but not limited thereto. From the viewpoint of preventing malfunction of a semiconductor device, carbon black is particularly preferable. Further, instead of carbon black, red, blue, green, yellow, and some other color pigments or dyes may be mixed to make a black color or an almost black color.

Examples of a red colorant include monoazo, disazo, azo lake, benzimidazolone, perylene, diketo-pyrrolo-pyrrole, condensed azo, anthraquinone, and quinacridone colorants, and specific examples thereof include the following: monoazo red colorants such as Pigment Red 1, 2, 3, 4, 5, 6, 8, 9, 12, 14, 15, 16, 17, 21, 22, 23, 31, 32, 112, 114, 146, 147, 151, 170, 184, 187, 188, 193, 210, 245, 253, 258, 266, 267, 268, and 269; disazo red colorants such as Pigment Red 37, 38, and 41; monoazo lake red colorants such as Pigment Red 48:1, 48:2, 48:3, 48:4, 49:1, 49:2, 50:1, 52:1, 52:2, 53:1, 53:2, 57:1, 58:4, 63:1, 63:2, and 64:1,68; benzimidazolone red colorants such as Pigment Red 171, Pigment Red 175, Pigment Red 176, Pigment Red 185, and Pigment Red 208; perylene red colorants such as Solvent Red 135, Solvent Red 179, Pigment Red 123, Pigment Red 149, Pigment Red 166, Pigment Red 178, Pigment Red 179, Pigment Red 190, Pigment Red 194, and Pigment Red 224; diketo-pyrrolo-pyrrole red colorants such as Pigment Red 254, Pigment Red 255, Pigment Red 264, Pigment Red 270, and Pigment Red 272; condensed azo red colorants such as Pigment Red 220, Pigment Red 144, Pigment Red 166, Pigment Red 214, Pigment Red 220, Pigment Red 221, and Pigment Red 242; anthraquinone red colorants such as Pigment Red 168, Pigment Red 177, Pigment Red 216, Solvent Red 149, Solvent Red 150, Solvent Red 52, and Solvent Red 207; and quinacridone red colorants such as Pigment Red 122, Pigment Red 202, Pigment Red 206, Pigment Red 207, and Pigment Red 209.

Examples of a blue colorant include phthalocyanine and anthraquinone colorants; examples of a blue pigment include compounds classified as Pigment, specifically, for example, Pigment Blue 15, Pigment Blue 15:1, Pigment Blue 15:2, Pigment Blue 15:3, Pigment Blue 15:4, Pigment Blue 15:6, Pigment Blue 16, and Pigment Blue 60. Examples of a blue dye that may be used include Solvent Blue 35, Solvent Blue 63, Solvent Blue 68, Solvent Blue 70, Solvent Blue 83, Solvent Blue 87, Solvent Blue 94, Solvent Blue 97, Solvent Blue 122, Solvent Blue 136, Solvent Blue 67, and Solvent Blue 70. As other examples, metal-substituted or unsubstituted phthalocyanine compounds may also be used.

Likewise, examples of a green colorant include phthalocyanine, anthraquinone, and perylene colorants; specifically Pigment Green 7, Pigment Green 36, Solvent Green 3, Solvent Green 5, Solvent Green 20, Solvent Green 28, or the like may be used. As other examples, metal-substituted or unsubstituted phthalocyanine compounds may also be used.

Examples of a yellow colorant include monoazo, disazo, condensed azo, benzimidazolone, isoindolinone, and anthraquinone colorants, and specific examples thereof include the following: anthraquinone yellow colorants such as Solvent Yellow 163, Pigment Yellow 24, Pigment Yellow 108, Pigment Yellow 193, Pigment Yellow 147, Pigment Yellow 199, and Pigment Yellow 202; isoindolinone yellow colorants such as Pigment Yellow 110, Pigment Yellow 109, Pigment Yellow 139, Pigment Yellow 179, and Pigment Yellow 185; condensed azo yellow colorants such as Pigment Yellow 93, Pigment Yellow 94, Pigment Yellow 95, Pigment Yellow 128, Pigment Yellow 155, Pigment Yellow 166, and Pigment Yellow 180; benzimidazolone yellow colorants such as Pigment Yellow 120, Pigment Yellow 151, Pigment Yellow 154, Pigment Yellow 156, Pigment Yellow 175, and Pigment Yellow 181; monoazo yellow colorants such as Pigment Yellow 1, 2, 3, 4, 5, 6, 9, 10, 12, 61, 62, 62:1, 65, 73, 74, 75, 97, 100, 104, 105, 111, 116, 167, 168, 169, 182, and 183; and disazo yellow colorants such as Pigment Yellow 12, 13, 14, 16, 17, 55, 63, 81, 83, 87, 126, 127, 152, 170, 172, 174, 176, 188, and 198.

In order to adjust the color tone, other colorants such as violet, orange, brown, or black colorants may be added. Specific examples include Pigment Violet 19, 23, 29, 32, 36, 38, 42, Solvent Violet 13, 36, C.I. Pigment Orange 1, C.I. Pigment Orange 5, C.I. Pigment Orange 13, C.I. Pigment Orange 14, C.I. Pigment Orange 16, C.I. Pigment Orange 17, C.I. Pigment Orange 24, C.I. Pigment Orange 34, C.I. Pigment Orange 36, C.I. Pigment Orange 38, C.I. Pigment Orange 40, C.I. Pigment Orange 43, C.I. Pigment Orange 46, C.I. Pigment Orange 49, C.I. Pigment Orange 51, C.I. Pigment Orange 61, C.I. Pigment Orange 63, C.I. Pigment Orange 64, C.I. Pigment Orange 71, C.I. Pigment Orange 73, C.I. Pigment Brown 23, C.I. Pigment Brown 25, C.I. Pigment Black 1, and C.I. Pigment Black 7.

In the case where a through-chip via is formed in the fan-out region of a FO-WLP, both the fan-out region and the warpage correction layer for the FO-WLP need to be simultaneously machined with laser beams, and thus it is preferable that the warpage correction layer is also light transmissive for alignment. A colorant component (E) may be selected as appropriate taking into consideration such cases.

From the viewpoint of higher light transmissivity into a deep region, which leads to a more preferable warpage correction layer, the content of the colorant component (E) is preferably 0.1 to 35 parts by mass, more preferably 0.5 to 25 parts by mass, and especially preferably 1 to 15 parts by mass with respect to 100 parts by mass of the total sum of the curable components (A1) and (B1), the curing agent components (A2) and (B2), and the reactive filmability imparting polymer component (C1) and the reactive filmability imparting polymer component (C2), as included in the curable resin

composition.

In the case where a warpage correction layer is disposed in a FO-WLP, in order to improve at least either of the adhesiveness and tackiness to an adherend (pseudo wafer) of the warpage correction layer, and the cohesiveness of the warpage correction layer, the curable resin composition according to the present invention may contain a coupling agent component (F1) having a functional group reactive with an inorganic substance and a functional group reactive with an organic functional group. When a warpage correction layer is formed by applying a coating of the curable resin composition to a FO-WLP and curing the curable resin composition, a coupling agent component (F1) contained in the composition makes it possible to improve the water resistance of the warpage correction layer without impairing the heat resistance thereof. Examples of such a coupling agent include a titanate coupling agent, an aluminate coupling agent, and a silane coupling agent, and among them a silane coupling agent is preferable.

Examples of an organic group to be contained in a silane coupling agent include a vinyl group, an epoxy group, a styryl group, a methacryloxy group, an acryloxy group, an amino group, an ureido group, a chloropropyl group, a mercapto group, a polysulfide group, and an isocyanate group. A commercially supplied silane coupling agent may be used, and examples thereof include KA-1003, KBM-1003, KBE-1003, KBM-303, KBM-403, KBE-402, KBE-403, KBM-1403, KBM-502, KBM-503, KBE-502, KBE-503, KBM-5103, KBM-602, KBM-603, KBE-603, KBM-903, KBE-903, KBE-9103, KBM-9103, KBM-573, KBM-575, KBM-6123, KBE-585, KBM-703, KBM-802, KBM-803, KBE-846, and KBE-9007 (all of them are trade names, manufactured by Shin-Etsu Chemical Co., Ltd.). These may be used singly, or in a mixture of two or more thereof.

The curable resin composition according to the present invention may contain various additives, if necessary, in addition to the above-described components. As examples of such various additives, additives conventionally known in the electronic materials field such as a leveling agent, a plasticizer, an antioxidant, an ion trapping agent, a gettering agent, a chain transfer agent, a release agent, an anticorrosive, an adhesion promoter, an ultraviolet absorber, a thermal polymerization inhibitor, a thickener, and an antifoamer may be contained.

The curable resin composition according to the present invention may contain an organic solvent. The organic solvent may be used for adjusting viscosity when a polyether compound containing an ethylenic unsaturated group in a molecule is synthesized, when individual components are mixed, and when the obtained curable resin composition is applied to a substrate or a support film.

Examples of the organic solvent include a ketone, an aromatic hydrocarbon, a glycol ether, a glycol ether acetate, an ester, an alcohol, an aliphatic hydrocarbon, and a petroleum solvent.

More specifically, the examples include: a ketone such as methyl ethyl ketone or cyclohexanone; an aromatic hydrocarbon such as toluene, xylene, and tetramethylbenzene; a glycol ether such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether, and triethylene glycol monoethyl ether; an ester such as ethyl acetate, butyl acetate, dipropylene glycol methyl ether acetate, propylene glycol methyl ether acetate, propylene glycol ethyl ether acetate, and propylene glycol butyl ether acetate; an alcohol such as ethanol, propanol, ethylene glycol, and propylene glycol; an aliphatic hydrocarbon such as octane and decane; and a petroleum solvent such as petroleum ether, petroleum naphtha, hydrogenated petroleum naphtha, and solvent naphtha. These organic solvents may be used singly or in combination of two or more thereof.

The maximum transmittance at a wavelength between 300 and 800 nm, which is a kind of a measure of transparency for at least one of visible light and ultraviolet light, of the curable resin composition according to the present invention is preferably 20% or less, more preferably 0 to 15%, further preferably 0 to 10%, and especially preferably 0.001 to 8%.

In the case where alignment is needed when a FO-WLP is produced from a pseudo wafer, the transmittance of the curable resin composition at a wavelength between 800 and 1,200 nm, which is a measure of transparency for infrared light, is preferably at least 50%, more preferably at least 55%, further preferably at least 60%, and especially preferably at least 65%.

By adjusting the transmittance of the curable resin composition at a wavelength between 300 and 800 nm and at a wavelength between 800 and 1,200 nm within the aforementioned ranges, the effect of improving alignment for semiconductor equipment and improving visibility of printing can be obtained.

The maximum transmittance of the curable resin composition at a wavelength between 300 and 800 nm and at a wavelength between 800 and 1,200 nm may be adjusted by the kind and content of the above-described colorant component (E). The maximum transmittance of the curable resin composition means herein the highest transmittance value (maximum transmittance) of the total light transmittance measured on a cured product (warpage correction layer (25 μm thick) obtained after curing the curable resin composition, at a wavelength between 300 and 1,200 nm using a UV-VIS spectrophotometer (manufactured by Shimadzu Corporation).

In the case where the curable resin composition of the present invention is formed into a film (or a sheet), its thickness is not limited to any specific value, but is preferably 3 to 300 μm, more preferably 5 to 250 μm, and especially preferably 7 to 200 μm.

When the curable resin composition according to the present invention includes, for example, a cyclic ether compound as the curable component (A1) and includes a compound containing at least one ethylenic unsaturated group in a molecule as the curable component (B1), the curable resin composition is initially adhesive, and thus the composition, when not cured yet, can easily stick to a pseudo wafer, a chip, or the like when pressed. While the curable resin composition is pressed, either of heating and pressurizing may be carried out. The composition then undergoes different curing reactions, and is eventually formed into a cured film (a warpage correction layer) that is highly adhesive and highly capable of warpage correction. A cured film (a warpage correction layer) formed by using the curable resin composition according to the present invention is excellent in adhesive strength and can retain a satisfactory protection feature even under a severely hot and humid condition. Note that the warpage correction layer obtained by curing the curable resin composition may have a single-layer or multilayer structure.

Before use, the curable resin composition according to the present invention may be turned into a dry film or may remain fluid. When in use in the fluid state, the composition may be a one-component or two-or-more component material.

To be formed into a dry film, the curable resin composition is diluted with an organic solvent to have a viscosity appropriately adjusted, and is applied in a uniform thickness to a support film by using a comma coater, a blade coater, a lip coater, a rod coater, a squeeze coater, a reverse coater, a transfer roll coater, a gravure coater, a spray coater, an inkjet machine, or the like, and then dried typically at a temperature of 50 to 130°C for 1 to 30 minutes.

Although no specific restriction is imposed on the thickness of a coating, in general, the thickness of a dried film is appropriately selected from a range of 5 to 150 μm, preferably from a range of 10 to 60 μm.

As the support film, conventionally known ones, as called separate paper, separate film, separate, release film, release paper, and the like, may be suitably used. In addition, a support film prepared by forming a release layer on one side or both sides of a release liner base made of a plastic film, such as a polyester film of poly(ethylene terephthalate) (PET), poly(ethylene naphthalate) (PEN), or the like, a polyolefin film of an oriented polypropylene film (OPP), or the like, and a polyimide film, may be also used. There is no particular restriction on a release layer, insofar as it is made of a material having a releasing characteristic, and examples thereof include a silicone resin, an organic resin-modified silicone resin, and a fluororesin.

Although no specific restriction is imposed on the thickness of a support film, in general, the thickness is appropriately selected from a range of 10 to 150 μm.

After the curable resin composition is applied to the support film, a removable cover film may further be layered on the coating for the purpose of, for example, preventing dust from sticking to the coating. Examples of the removable cover film include a polyethylene film, a polytetrafluoroethylene film, a polypropylene film, and a surface-treated paper sheet. In view of removal of the cover film, the coating is to be less adhesive to the cover film than to the support film.

In the case where the curable resin composition of the present invention is used in the fluid state, a dried coating thereof can be formed by, for example, adjusting the viscosity of the composition with an organic solvent so as to be suitable for the intended coating method, and then coating a substrate with the composition by using a dip coating method, a flow coating method, a roll coating method, a bar coater method, a screen printing method, a curtain coating method, or the like, and drying by volatilization (preliminary drying) of the organic solvent included in the composition at a temperature of about 60 to 100°C.

When the curable resin composition of the present invention is used in the fluid state, an inkjet printing method may be used to form a coating. In this case, when, for example, a coating is formed on a desired area of the pseudo wafer for a FO-WLP, the inkjet printing method may be used to apply the curable resin composition to the area except those areas where an electrode pad, an electrode via, or an alignment mark is disposed on the pseudo wafer. As a result, the subsequent step of opening an electrode portion can be omitted or an alignment mark can be more visible while the effect of warpage correction is exerted.

Although no specific restriction is imposed on the thickness of a coating, in general, the thickness of a dried coating is selected as appropriate preferably from a range of 3 to 100 μm, and more preferably from a range of 5 to 70 μm. In addition, the coating having a desired thickness may be formed by a single coating process or by two or more recoating processes.

For drying by volatilization carried out after the curable resin composition of the present invention is applied, a hot air circulating drying oven, an IR oven, a hot plate, a convection oven, or the like (a method for causing the composition to be in countercurrent contact with hot air in a dryer using a steam-based air heating heat source and a system for spraying from a nozzle to the support) may be used.

<Uses of the curable resin composition>

The following describes a pseudo wafer for a FO-WLP having a warpage correction layer disposed, where the above-described curable resin composition is used as a composition for forming the warpage correction layer for the FO-WLP.

First, a semiconductor wafer is prepared and circuits are formed on one side of the wafer. The semiconductor

wafer may be a silicon wafer or may be a compound semiconductor wafer such as a Gallium Arsenide (GaAs) semiconductor. For forming circuits on the wafer, any of various methods including a general-purpose etching process and a lift-off process may be used. The semiconductor wafer may also be cut into separate semiconductor chips through a dicing process.

The semiconductor chips thus obtained are mounted on a plate-like carrier having a smooth surface via an adhesive layer. Although no specific limitation is imposed on the carrier, a circular or rectangular silicon wafer or a metal plate may be used as the carrier. As the adhesive layer, a material that can temporarily fix the semiconductor chips and can be peeled off after production of the pseudo wafer is used. As an example of such adhesive layer material, an acrylic pressure sensitive adhesive, a rubber pressure sensitive adhesive, or a styrene-conjugated diene block copolymer may be used. In addition, the adhesive layer material may contain a resin that includes a carboxyl group having an ethylenic unsaturated group and may contain a radical polymerization initiator as described above. The adhesive layer containing such resin can have a variable degree of adhesiveness through heating or irradiation with active energy rays.

The semiconductor chips are placed on the adhesive layer such that each of the semiconductor chips is spaced apart. When seen in a planar view, the semiconductor chips may be arranged in the same or different number of chips along the column and row directions, and, from various viewpoints such as improving densities or ensuring a certain area of terminals per unit of semiconductor chips, the semiconductor chips may be arranged to be symmetrical about a point or in a reticular pattern. Although no specific limitation is imposed on the distance between adjacent semiconductor chips, it is preferable that the semiconductor chips are placed so as to be able to allocate a fan-out (FO) region necessary for forming connection terminals for a FO-WLP to be finally obtained.

Next, the semiconductor chips placed on the plate-like carrier via the adhesive layer are sealed with an encapsulant. The semiconductor chips are placed and the encapsulant is applied or adhered to the carrier such that the side walls and top face (the face opposite to the face where circuits are formed) of each semiconductor chip are sealed with the encapsulant. During this operation, the encapsulant is also formed to be embedded in the space between semiconductor chips. The semiconductor chip's side walls and the face where circuits are formed may also be sealed with the encapsulant. In this case, it is preferable that at least circuit terminals are exposed. For this purpose, the semiconductor chip may be sealed in such a way that circuit terminals are exposed, or may be polished in a subsequent step so that circuit terminals are exposed. The sealing process involving such encapsulant can be established by using a known liquid, granular, or sheet-like resin composition for sealing semiconductors to carry out compression molding. Major materials used in known resin compositions for sealing semiconductors include an epoxy resin, a curing agent for an epoxy resin, a curing accelerator, and a spherical filler.

After the encapsulant is cured, the plate-like carrier is peeled off. The peeling takes place between the adhesive layer and the semiconductor chip with the encapsulant. Examples of the peeling method include giving heat treatment to change (decrease) the adhesion of the adhesive layer, thereby peeling off the carrier, or peeling off the plate-like carrier from the adhesive layer first, and then giving heat treatment or irradiation with electron rays or ultraviolet rays to the adhesive layer to remove the adhesive layer.

On the pseudo wafer thus obtained, postcure may be carried out. The postcure may be performed, for example, at a temperature within a range of 150 to 200°C and for a time within a range of 10 minutes to 8 hours. After that, the resulting pseudo wafer may be thinned by grinding the face opposite to the face where the semiconductor is embedded. No specific limitation is imposed on the method of grinding, and thus any known means, such as a grinder, may be used to grind the face. Although no specific limitation is imposed on the thickness of the pseudo wafer that has been ground, the thickness is usually about 50 to 500 $\mu$m.

Next, a redistribution layer is formed on the face of the pseudo wafer, on which face circuits of the semiconductor chip are exposed. First, by using a spin coating method or the like, a redistribution insulating resin is applied to the entire face of the pseudo wafer where circuits of the semiconductor chip are exposed, and then prebaked at about 100°C, thereby forming the redistribution insulating resin layer. Next, for the purpose of opening a connection pad in the semiconductor chip, a pattern is formed on the redistribution insulating resin layer by using photolithography or the like, and then the redistribution insulating resin layer is heated (cured). The heating may be performed, for example, at a temperature within a range of 150 to 250°C and for a time within a range of 10 minutes to 5 hours. Although the redistribution insulating resin layer is not limited to any specific material, from the viewpoint of heat resistance and reliability, a polyimide resin, a polybenzoxide resin, or a benzocyclobutene resin, for example, is used. As described above, when the redistribution insulating resin is heated, the pseudo wafer may be caused to warp by the heat-shrunk insulating resin.

A power feeding layer is formed over the entire face of the redistribution layer of the pseudo wafer by using spattering or some other method. Then, a resist layer is formed on the power feeding layer, a predetermined pattern is exposed to light and developed, and then a via and a redistribution circuit are formed by electrolyte copper plating. After the redistribution circuit is formed, the resist layer is removed and the power feeding layer is etched.

Next, solder balls are attached to a land that is disposed on the redistribution circuit, by applying a flux to the land, placing the solder balls thereon, and melting the solder balls with heat. A solder resist layer may be formed so as to partially cover the redistribution circuit and the solder balls. As examples of the applied flux, a resin-based or water-soluble flux may

be used. As examples of the method for melting with heat, a reflow method or a hot plate may be used. In this way, a pseudo wafer for a FO-WLP is obtained.

Then, the pseudo wafer for a FO-WLP is separated into pieces through a dicing or some other process to provide FO-WLPs.

The curable resin composition is applied to form a coating on the face of the thus-obtained pseudo wafer opposite to the face on which the redistribution layer is formed. In the case where the curable resin composition in the form of a dry film as described above is used, the dry film is applied to the face. As the method for the application, any known method involving a hand roller, a laminator, a vacuum laminator, compression molding, or the like may be used.

The dry film may be heated during the application process; provided, however, the dry film is preferably heated to the extent that the curable resin composition does not start a thermal curing reaction. As a temperature at which the thermal curing reaction is started, the ONSET temperature, for example, may be found in reaction heat observed in a DSC measurement, and the thermal curing reaction temperature may be set to the ONSET temperature or lower. In the DSC measurement, the ONSET, Peak Top, and OFFSET temperatures may be determined by, for example using DSC Q100 supplied by TA Instruments, Inc. and heating the curable resin composition under a nitrogen atmosphere to 30 to 300°C at elevated temperature of 5°C/min.

Then, the support film is removed from the dry film to yield a laminate of the pseudo wafer and the dry film.

Next, the dry film is cured to form a warpage correction layer. When the dry film (the curable resin composition) includes a curable component that is caused to develop a curing reaction by active energy rays, the exposure portion (the portion irradiated with active energy rays) can be cured by irradiating the portion with active energy rays. The exposure may be performed by irradiating the entire face of the unreacted dry film with active energy rays, or may be performed with active energy rays on a contact or non-contact basis through a photomask where a pattern is formed. Alternatively, the exposure portion may be light-cured through direct pattern exposure using a laser direct exposure machine.

In the case of exposure with a patterned photomask or direct pattern exposure with a laser direct exposure machine, when the exposure is partially made, a light-sensitive pattern for the warpage correction layer may be formed by developing the unexposed portion with a dilute alkaline aqueous solution (for example, a 0.3 to 3 wt% tetramethylammonium hydroxide (TMAH) aqueous solution or a 0.3 to 3 wt% sodium carbonate aqueous solution), or a light-cured portion and an uncured portion may be formed without development.

In the case of exposure with a photomask or direct pattern exposure with a laser direct exposure machine, the pattern shape may be selected from regular patterns such as a grid pattern, a checkerboard pattern, and a dot pattern. The repeating units of opening and light-blocking patterns are preferably smaller than the size of the semiconductor package to be finally obtained. Different patterns may be used on the pseudo wafer for a FO-WLP between the area where a semiconductor chip is present and the resin area forming the pseudo wafer.

During exposure, the reaction state of the warpage correction layer may be changed in the plane by irradiating the layer with active energy rays while continuously or discontinuously changing, from the center toward the perimeter of the wafer, the pattern or the aperture ratio calculated from "opening portions/light-blocking portions" of a photomask. In the case of direct pattern exposure with a laser direct exposure machine, the entire surface may be exposed in a uniform pattern or may be exposed ununiformly. In addition, the pattern to be exposed may be continuously or discontinuously changed.

As an example of the light exposure machine used for radiation of active energy rays, an apparatus equipped with a high-pressure mercury lamp, an ultrahigh pressure mercury lamp, a metal halide lamp, a mercury short arc lamp, or the like and emitting ultraviolet rays in a range of 350 to 450 nm may be used.

A direct imaging device (for example, a laser direct imaging device capable of directly writing images from the CAD data in a computer) may also be used. Either of a gas laser and a solid-state laser may be used as the laser source for a direct imaging device, provided that the maximal wavelength falls within a range of 350 to 410 nm.

Although the exposure amount varies with factors such as the film thickness, it is typically in a range of 10 to 10,000 $mJ/cm^2$, and preferably in a range of 20 to 8,000 $mJ/cm^2$.

Examples of the development method include dip development, shower development, spray development, and brush development. As the developing fluid, an aqueous solution of an alkali such as tetramethylammonium hydroxide (TMAH), potassium hydroxide, sodium hydroxide, sodium carbonate, potassium carbonate, sodium phosphate, sodium silicate, ammonia, and an amine may be used.

In the present invention, the amount of warpage correction can be conveniently adjusted depending on how much the FO-WLP is warped, where the adjustment is made as appropriate by controlling the degree of cure of the warpage correction layer on the pseudo wafer through selection of an irradiation level of active energy rays or selection of either full or partial irradiation, or through a development process in the case of partial irradiation.

When the dry film (the curable resin composition) includes a curable component that is caused to develop a curing reaction with heat, the curing reaction is allowed to proceed by heating. As examples of the method of heating, heating with an oven, heating with hot air heated by a hot plate, heating with infrared rays, a convection oven, or the like (a method for causing the composition to be in countercurrent contact with hot air in a dryer using a steam-based air heating

heat source and a system for spraying from a nozzle to the support) may be used.

As a temperature at which the dry film is cured with heat to be formed into a warpage correction layer, the ONSET temperature, for example, may be found in reaction heat observed in a DSC measurement, and the temperature may be set to the ONSET temperature or higher. In addition, the temperature is preferably set to a temperature not lower than the Peak Top temperature and not higher than the OFFSET temperature. In the DSC measurement, the ONSET, Peak Top, and OFFSET temperatures may be determined by, for example using DSC Q100 supplied by TA Instruments, Inc. and heating the warpage correction material for a FO-WLP under a nitrogen atmosphere to 30 to 300°C at elevated temperature of 5°C/min.

In the present invention, the amount of warpage correction can be conveniently adjusted depending on how much the FO-WLP is warped, where the adjustment is made as appropriate by controlling the degree of cure of the warpage correction layer on the pseudo wafer through adjustment of time and temperature for thermal curing, through one step heating to a target temperature, or through stepped heating via an intermediate temperature to a final temperature. When cured with heat, the dry film is heated preferably for 30 seconds to 3 hours.

When the dry film (the curable resin composition) includes both of the component which reacts with active energy rays and the component which reacts with heat, the curable resin composition can be cured by using both of irradiating with active energy rays and heating. The irradiating with active energy rays and the heating may or may not take place simultaneously. The irradiating with active energy rays may be performed once or more than once. Likewise, the heating for thermal curing may be performed once or more than once.

When the dry film (the curable resin composition) includes both of the component which reacts with active energy rays and the component which reacts with heat, from the viewpoint of curing reactivity, any of the following methods is preferable: a method including performing irradiation with active energy rays and heating simultaneously; a method including irradiation with active energy rays followed by heating; a method including heating followed by irradiation with active energy rays; and a method including irradiation with active energy rays followed by heating and further followed by irradiation with active energy rays.

Even after the warpage correction layer is formed by curing the dry film (the curable resin composition) through irradiation with active energy rays and/or heating, the amount of warpage correction, if not enough, can be increased by additionally performing irradiation with active energy rays and/or heating to further promote reactions.

## EXAMPLES

The present invention will be described by way of Examples, provided that the present invention is not limited to these Examples. Meanwhile, "parts" and "%" mean herein parts by mass, unless otherwise specified.

<Preparation of curable component (B1)1>

Into an autoclave equipped with a thermometer, a nitrogen feeding device-cum-alkylene oxide feeding device, and a stirrer, 119.4 parts of a novolak cresol resin (SHONOL CRG951 manufactured by Showa Denko K.K., OH equivalent: 119.4), 1.19 parts of potassium hydroxide, and 119.4 parts of toluene were charged, and the system was purged with nitrogen with stirring, and heated. Next, 63.8 parts of propylene oxide was dropped gradually to continue a reaction at 125 to 132°C, and 0 to 4.8 kg/cm$^2$ for 16 hours. Thereafter, the reaction solution was cooled down to room temperature, to which 1.56 parts of 89% phosphoric acid was added, and the solution was mixed to neutralize potassium hydroxide to obtain a reaction solution of propylene oxide with a novolak cresol resin with a nonvolatile matter content of 62.1% and a hydroxyl value of 182.2 g/eq. This means that on average 1.08 mol of alkylene oxide was added per 1 equivalent of phenolic hydroxyl group.

Into a reactor equipped with a stirrer, a thermometer, and an air blow-in tube, 293.0 parts of the obtained reaction solution of an alkylene oxide with a novolak cresol resin, 43.2 parts of acrylic acid, 11.53 parts of methanesulfonic acid, 0.18 parts of methylhydroquinone, and 252.9 parts of toluene were charged, into which air was blown at a rate of 10 mL/min and a reaction was carried out at 110°C for 12 hours with stirring. Water produced by the reaction was distilled out as an azeotropic mixture with toluene in an amount of 12.6 parts. Thereafter, the product was cooled to room temperature, and the obtained reaction solution was neutralized with 35.35 parts of a 15% aqueous solution of sodium hydroxide, and then washed with water. Thereafter, toluene was distilled off in an evaporator by replacing with 118.1 parts of diethylene glycol monoethyl ether acetate (carbitol acetate) to obtain a novolak acrylate resin solution.

Next, 332.5 parts of the novolak acrylate resin solution obtained and 1.22 parts of triphenylphosphine were charged into a reactor equipped with a stirrer, a thermometer, and an air blow-in tube, and 60.8 parts of tetrahydrophthalic anhydride was gradually added while blowing in air at a rate of 10 mL/min with stirring and allowing a reaction at 95 to 101°C for 6 hours followed by cooling to obtain an acryl-containing polyether compound solution, which was a curable component (B1)1 having a solid content acid value of 88 mg KOH/g and a solid content of 70.9%.

<Preparation of curable component (B1)2>

220 parts (1 equivalent) of a cresol novolak epoxy resin (EOCN-104S manufactured by Nippon Kayaku Co., Ltd., epoxy equivalent 220 g/eq), 140.1 parts of carbitol acetate, and 60.3 parts of solvent naphtha were charged into a flask, and heated to 90°C with stirring to be dissolved. The obtained solution was once cooled to 60°C, and then 72 parts (1 mol) of acrylic acid, 0.5 parts of methylhydroquinone, and 2 parts of triphenylphosphine were added, heated to 100°C and allowed to continue reaction for about 12 hours to obtain a reaction product having an acid value of 0.2 mg KOH/g. 80.6 parts (0.53 mol) of tetrahydrophthalic anhydride was added to the reaction product, which was then heated to 90°C and allowed to continue reaction for 6 hours, to obtain an acryl-containing polyether compound solution, which was a curable component (B1)2 having a solid acid value of 85 mg KOH/g and a solid content of 64.9%.

<Synthesis of curing agent component (A2-1)1>

To a 2,000 mL flask equipped with a stirrer and a cooling tube, 377 g of tripropylene glycol monomethyl ether was added and heated to 90°C under a stream of nitrogen. A dissolved mixture of 104.2 g of styrene, 246.5 g of methacrylic acid, and 20.7 g of dimethyl 2,2'-azobis(2-methylpropionate) (V-601 manufactured by Wako Pure Chemical Corporation) was dropped to the flask for four hours. This yielded a carboxyl group-containing resin solution representing a curing agent component (A2-1)1. The carboxyl group-containing resin solution had a solid acid value of 120 mg KOH/g, a solid content of 50%, and a weight average molecular weight of $2 \times 10^4$.

<Preparation of filmability imparting polymer (C1)>

25 g of a Y-X-Y type block copolymer (M52N manufactured by Arkema S.A.) was added to 75 g of diethylene glycol monoethyl ether acetate (CA) and dissolved by stirring and heating at 80°C. The obtained product was used as the filmability imparting polymer C1.

<Preparation of curable resin compositions 1 to 11>

For each of the curable resin compositions, the components in contents listed in Table 1 below were blended, preliminarily mixed with a stirrer, and dispersed and kneaded with a three-roll mill to prepare each individual curable resin composition. Note that the contents listed in the table are in units of parts by mass. Note that contents of the curable component (B1), the curing agent component (A2-1), and the filmability imparting polymer (C1) listed in the table represent solid contents.

[Table 1]

| Group | Component | Curable resin composition | | | | | | | | | | |
|---|---|---|---|---|---|---|---|---|---|---|---|---|
| | | 1 | 2 | 3 | 4 | 5 | 6 | $7^{+}$ | 8 | $9^{+}$ | $10^{+}$ | $11^{+}$ |
| Curable Component (A1) | N-770 | 20 | 40 | | 10 | 10 | 10 | 20 | 7 | | 40 | |
| | jER 828 | 20 | 40 | | 20 | 20 | 20 | 20 | 7 | | 40 | |
| | jER 1007 | 40 | 40 | 40 | | | | 40 | | | 40 | |
| Heat curing agent component (A2-1) | 1B2PZ | 0.5 | 1 | 0.3 | 0.3 | 0.3 | 0.3 | | 0.3 | | 1 | |
| | DICY7 | | | | 2 | 2 | 2 | | | | | |
| | Curing agent component (A2-1)1 | | | | | | | | 100 | | | |
| Light curing agent component (A2-2) | SP-152 | | | | | | | 5 | | | | |

(continued)

| Group | Component | Curable resin composition | | | | | | | | | | |
|---|---|---|---|---|---|---|---|---|---|---|---|---|
| | | 1 | 2 | 3 | 4 | 5 | 6 | 7+ | 8 | 9+ | 10+ | 11+ |
| Curable Component (B1) | Curable Component (B1)1 | 150 | 20 | | 40 | 40 | 40 | 50 | | 185 | | |
| | Curable Component (B1)2 | | | | 100 | 100 | 100 | | | | | |
| | TMPTA | | 20 | 30 | | | | 50 | 30 | | | 30 |
| | DPHA | 10 | | | 20 | 20 | 20 | | | 15 | | |
| | DCPA | | | 10 | | | | | 10 | | | 10 |
| Light curing agent component (B2-2) | IRGACURE TPO | 10 | 5 | 10 | 10 | | 10 | | 10 | 10 | | 10 |
| | IRGACURE 907 | | | | | 15 | | | | | | |
| | IRGGACURE OXE02 | | | | | 1 | | | | | | |
| Heat curing agent component (B2-1) | PERCUMYL D | | | | | | | 7 | | | | |
| Filmability imparting polymer component (C1) | M52N | 25 | 50 | 85 | | | | 50 | | 25 | 50 | 85 |
| Inorganic filler component (D) | Silica | 100 | 100 | 100 | 35 | 35 | 35 | 35 | 100 | 100 | 100 | 100 |
| | Barium sulfate | | | | 70 | 70 | 70 | 70 | | | | |
| Colorant component (E) | Blue colorant | 0.8 | 0.8 | 0.8 | 0.8 | 0.8 | 0.4 | 0.8 | 0.8 | 0.8 | 0.8 | 0.8 |
| | Yellow colorant | 0.5 | 0.5 | 0.5 | 0.5 | 0.5 | 0.3 | 0.5 | 0.5 | 0.5 | 0.5 | 0.5 |
| | Red colorant | 1.5 | 1.5 | 1.5 | 1.5 | 1.5 | 0.7 | 1.5 | 1.5 | 1.5 | 1.5 | 1.5 |
| + Comparative Example | | | | | | | | | | | | |

Details of the components in Table 1 are as follows:

N-770: phenol novolak epoxy resin, EPICLON N-770 manufactured by DIC Corporation
jER 828: bisphenol A epoxy resin (basic liquid type epoxy resin), "828" manufactured by Mitsubishi Chemical Corporation
jER 1007: bisphenol A epoxy resin (basic solid type epoxy resin), "1007" manufactured by Mitsubishi Chemical Corporation
1B2PZ: 1-benzyl-2-phenylimidazole, 1B2PZ manufactured by Shikoku Chemicals Corporation
DICY7: dicyandiamide, DICY7 manufactured by Mitsubishi Chemical Corporation
SP-152: triarylsulfonium salt, Adekaoptomer SP-152 manufactured by ADEKA Corporation
TMPTA: trimethylolpropane triacrylate, TMPT manufactured by Daicel-Allnex Ltd.
DPHA: dipentaerythritol hexaacrylate, DPHA manufactured by Daicel-Allnex Ltd.
DCPA: dimethylol tricyclodecane diacrylate, LIGHT ACRYLATE DCP-A manufactured by Kyoeisha Chemical Co., Ltd.
IRGACURE TPO: IRGACURE TPO manufactured by BASF Japan Ltd.
IRGACURE 907: IRGACURE 907 manufactured by BASF Japan Ltd.

IRGACURE OXE02: IRGACURE OXE02 manufactured by BASF Japan Ltd.
PERCUMYL D: dicumyl peroxide, PERCUMYL D manufactured by NOF Corporation
M52N: Y-X-Y type block copolymer, Nanostrength M52N manufactured by Arkema S.A.
Silica: ADMAFINE SO-E2 manufactured by Admatechs Co., Ltd.
Barium sulfate: surface treatment barium sulfate, B-30 manufactured by Sakai Chemical Industry Co., Ltd.
Blue colorant: C.I. Pigment Blue 15:3
Yellow colorant: C.I. Pigment Yellow 147
Red colorant: Paliogen Red K3580 manufactured by BASF Japan Ltd.

Note that contents of the curing agent component (A2-1)1, the curable component (B1)1, and the curable component (B1)2 listed in the table represent values in terms of solid contents.

<Measurement of volume contraction ratio of curable component (A1)>

The volume contraction ratio of each of the curable components (A1) in Table 1 that have been thermally cured with the heat curing agent component was measured. The curable component (A1) in the content listed in Table 1 was mixed in the curable resin composition 1 in Table 1 so that the total mass was 10.0 g. The mixture was stirred while heated if necessary, and 0.2 g of 2-ethyl-4-methylimidazole, which is a heat curable component, was further added thereto to prepare a mixture.

When the prepared mixture was in a fluid state at 25°C, the mixture was added into a 10 mL measuring cylinder, left in a room at 25°C for 6 hours, and then the mass was measured. The density was calculated from the actually measured volume and the mass. When the prepared mixture was in a solid state at 25°C, the mixture was heated and then cooled to room temperature to yield a solid matter. The density (ρ) of the solid matter was calculated by using XS-205 Analytical Balance and the density measurement kit "Solid and Liquid Density Determination" manufactured by Mettler-Toledo AG, as well as using distilled water as the displaced fluid, and in accordance the following equation:

$$\rho = (\alpha \times \rho_0) / (\alpha - \beta)$$

wherein ρ represents the density of a solid, a represents the mass of the solid in atmosphere, β represents the mass of the solid in a displaced fluid, and $\rho_0$ represents the density of distilled water at a measurement temperature.

Next, 5.0 g of the prepared composition was loaded in a container made from Teflon® and having a diameter of 2 cm and a height of 2 mm, and was charged to an oven heated to 100°C for 60 minutes, and then charged to an oven heated to 150°C for 60 minutes so that the curable component was cured, thereby yielding a cured product A. The density of the cured product A was measured with an analytical balance in the same manner as above.

From the density of the fluid or solid matter of the mixture and from the density of the cured product, the volume contraction ratio of the curable component (A1) was calculated in accordance with the following equation.

Volume contraction ratio = (1 - (density of curable component (A1) before curing)/(density after curing) × 100

In addition, the volume contraction ratio of the curable component (A1) used in each of the curable resin compositions 2 to 11 was calculated in the same manner as above.

Volume contraction ratios (%) of the curable components (A1) used in the curable resin compositions 1 to 11 are shown in Table 3 below.

<Measurement of volume contraction ratio of curable component (B1)>

The volume contraction ratio of each of the curable components (B1) in Table 1 that have been light-cured with the light curing agent component was measured. The curable component (B1) in the content listed in Table 1 was mixed in the curable resin composition 1 in Table 1 so that the total mass was 10.0 g. The mixture was stirred while heated if necessary, and 0.2 g of IRGACURE TPO manufactured by BASF Japan Ltd, which is a light curable component, was further added thereto to prepare a mixture.

When the prepared mixture was in a fluid state at 25°C, the mixture was added into a 10 mL measuring cylinder, left in a room at 25°C for 6 hours, and then the mass was measured. The density was calculated from the actually measured volume and the mass. When the prepared mixture was in a solid state at 25°C, the mixture was heated and then cooled to room temperature to yield a solid matter. The density of the solid matter was calculated in the same manner as above.

Next, 0.15 g of the prepared composition was loaded in a container made from Teflon® and having a diameter of 2 cm and a height of 0.5 mm, and was irradiated with active energy rays from a metal halide lamp (exposure amount: 5,000

mJ/$cm^2$) to cure the curable component, thereby yielding a cured product B. The density of the cured product B was measured with an analytical balance in the same manner as above.

From the density of the fluid or solid matter of the mixture and from the density of the cured product, the volume contraction ratio of the curable component (B1) was calculated in accordance with the following equation.

Volume contraction ratio = (1 - (density of curable component (B1) before curing)/(density after curing) $\times$ 100

In addition, the volume contraction ratio of the curable component (B1) used in each of the curable resin compositions 2 to 11 was calculated in the same manner as above.

Volume contraction ratios (%) of the curable components (B1) used in the curable resin compositions 1 to 11 are shown in Table 3 below.

<Production of dry film>

Each of the curable resin compositions 1 to 11 was diluted with methyl ethyl ketone as appropriate, and was applied to a PET film (FB-50 manufactured by Toray Industries, Inc., 16 $\mu$m) so as to be a 40 $\mu$m thick coating after dried, and then dried at 80°C for 30 minutes to provide dry films 1 to 11.

<Preparation of pseudo wafer>

A p-type 4 inch size and 150 um thick silicon wafer having a 100 nm $SiO_2$ film formed on one side thereof, as manufactured by Canosis Co., Ltd., was diced into 10 mm $\times$ 10 mm square semiconductor chips by using a dicing machine. A temporary fixing film was placed on a planar base plate made of stainless steel, and the aforementioned semiconductor chips were placed such that the $SiO_2$ face came into contact with the temporary fixing film and that 5 $\times$ 5 chips were arranged and spaced apart by 10 mm along the column and row directions. A sheet form semiconductor encapsulant of 100 mm $\times$ 100 mm square was layered thereon such that their central points substantially agreed, and the laminate was compression molded at 150°C for 1 hour using a heat press machine. To obtain the semiconductor encapsulant, the kneaded product having the components listed below was placed between two sheets of a 50 um cover film (PUREX film of Teijin Limited), and formed into a 200 um-thick sheet by a flat plate pressing method.

<Preparation of semiconductor encapsulant composition>

The following components were blended and heated in a roll kneader at 70°C for 4 minutes and subsequently at 120°C for 6 minutes totally 10 minutes, during which the blend was melt-kneaded under reduced pressure (0.01 kg/$cm^2$) to prepare a kneaded product.

- Naphthalene epoxy resin: 30 parts (NC-7000 manufactured by Nippon Kayaku Co., Ltd.)
- Bixylenol epoxy resin: 10 parts (YX-4000 manufactured by Mitsubishi Chemical Corporation)
- Phenol novolak epoxy resin: 10 parts (DEN-431 manufactured by The Dow Chemical Company)
- Anthraquinone: 2 parts
- Carbon black: 10 parts (Carbon MA-100 manufactured by Mitsubishi Chemical Corporation)
- Spherical silica: 500 parts (ADMAFINE SO-E2 manufactured by Admatechs Co., Ltd.)
- Silane coupling agent: 2 parts (KBM-403 manufactured by Shin-Etsu Chemical Co., Ltd.)
- 2-phenylimidazole: 2 parts (2PZ manufactured by Shikoku Chemicals Corporation)

Next, the temporary fixing film was peeled off from the obtained laminate and the back side was polished to complete a 100 mm $\times$ 100 mm square and 200 um thick pseudo wafer.

On the semiconductor circuit face of the obtained pseudo wafer, a positive-type resin composition having the following components for forming a redistribution layer was applied by using a spin coater, and then prebaked by heating at 100°C for 20 minutes. After prebaking, the photosensitive resin layer for forming a redistribution layer was 10 um thick formed on the pseudo wafer.

<Preparation of resin composition for forming redistribution layer>

First, 2,2-bis(3-amino-4-hydroxyphenyl)-propane was dissolved in N-methylpyrrolidone, and was reacted at 0 to 5°C with 4,4'-diphenyl ether dicarboxylic acid chloride in N-methylpyrrolidone, which was added dropwise, thereby synthesizing polyhydroxyamide (a precursor of polybenzoxazole) having a weight-average molecular weight of $1.3 \times 10^4$.

Next, the following components including a polyhydroxy amide resin were blended, and the mixed solution was filtered with pressure through a 3 μm pore Teflon® filter to prepare the resin component for forming a redistribution layer.

- Polyhydroxy amide resin (Z2): 100 parts
- Phenol novolak epoxy resin: 10 parts (DEN-431 manufactured by The Dow Chemical Company)
- 1-naphthoquinone-2-diazido-5-sulfonic acid ester: 10 parts (trade name TPPA528 manufactured by AZ Electronic Materials plc)
- Y-X-Y type block copolymer: 5 parts (Nanostrength M52N manufactured by Arkema S.A.)
- Silane coupling agent: 2 parts (KBM-403 manufactured by Shin-Etsu Chemical Co., Ltd.)
- γ-butyrolactone: 30 parts
- Propylene glycol monomethyl ether acetate: 120 parts

Next, the pseudo wafer was photo-irradiated in a positive type pattern in an exposure amount of 500 $mJ/cm^2$, by using HMW680GW (a metal halide lamp) manufactured by ORC Manufacturing Co., Ltd., through a photomask having a pattern of 100 um circular openings arranged in a matrix with 400 um pitches, followed by development with a 2.38 wt% TMAH aqueous solution at 25°C for two minutes, thereby forming a redistribution resin layer in which a pattern of circular openings was formed. After that, the pseudo wafer was baked at 200°C for one hour and then cooled to room temperature. The pseudo wafer thus obtained had warpage being concave on the redistribution resin layer side. The amount of concave warpage was 6 mm at the center relative to the perimeter of the 100 mm × 100 mm square.

To the face of the pseudo wafer opposite to the face on which circuits were formed (that is, the face on which the redistribution resin layer was formed), each of the dry films obtained as above was applied by using a vacuum laminator. Then, the dry film was cured under a combined exposure and heating condition indicated in Table 2. In the case where an exposure step was carried out before a heating step, the support film was peeled off after the exposure step, and then the heating step was carried out. The steps of curing reaction in Table 2 were carried out in the order of 1, 2, and 3.

[Table 2]

| Step | Curing condition | Dry film (curable resin composition) | | | | | | | | | | |
|---|---|---|---|---|---|---|---|---|---|---|---|---|
| | | 1 | 2 | 3 | 4 | 5 | 6 | 7+ | 8 | 9+ | 10+ | 11+ |
| 1 | Curable Component (B1) | UV1 | UV2 | UV3 | - | UV1 | UV1 | UV2 | UV3 | UV1 | - | UV3 |
| 2 | Curable Component (A1) | K1 | K1 | K1 | K1 | K1 | K1 | K1 | K1 | - | K1 | - |
| 3 | Curable Component (B1) | UV2 | UV4 | - | UV1 | - | - | UV4 | - | UV2 | - | - |
| + Comparative Example | | | | | | | | | | | | |

The horizontal line (-) in Table 2 represents that the corresponding step was not carried out. UV1, UV2, UV3, UV4, and K1 therein represent the curing conditions described below.

UV1: full irradiation with 3,000 $mJ/cm^2$ under 25°C condition using a metal halide lamp
UV2: full irradiation with 2,000 $mJ/cm^2$ under 25°C condition using a metal halide lamp
UV3: full irradiation with 1,500 $mJ/cm^2$ under 25°C condition using a metal halide lamp
UV4: irradiation of the embedded semiconductor chip only through a pattern mask with 2,000 $mJ/cm^2$ under 25°C condition using a metal halide lamp
K1: heating at 170°C for one hour

<Measurement of warpage of pseudo wafer>

After the warpage correction layer was formed on the pseudo wafer by curing the dry film as described above, the amount of warpage of the pseudo wafer was measured. The warpage amount was measured at 25°C with a long jaw caliper. The pseudo wafer was determined to be good (○) when the warpage amount at the center was within a range of ±2 mm relative to two points on the perimeter of the pseudo wafer. The pseudo wafer was determined as △ when the amount was within ±2 to 3 mm, and determined to be bad (×) when the amount was out of ±3 mm. Once determined as ×, the pseudo wafer was not subjected to subsequent evaluations. The evaluation results were as shown in the following Table 3.

<Reliability testing on pseudo wafer>

The wafers achieving good results in the above-described warpage evaluation were diced into chips. Reliability

tests were conducted on every 10 samples under a single condition through solder heat resistance tests (10 seconds at 260°C, three times) and 500 hot-cold cycles (one cycle is made up of leaving the samples at -40°C for 15 minutes and then leaving them at 125°C for 15 minutes). Then, a cross section of the pseudo wafer was observed under a microscope. The boundaries to which the curable resin composition was sticking were examined to find whether the wafer was defective with a peeled portion. The wafer was determined to be acceptable (○) when no sample out of ten samples had peeling, while the wafer was determined to be unacceptable (×) when at least one of the ten samples had peeling. The evaluation results were as shown in the following Table 3.

[Table 3]

| Evaluation item | Dry film (curable resin composition) | | | | | | | | | | |
|---|---|---|---|---|---|---|---|---|---|---|---|
| | 1 | 2 | 3 | 4 | 5 | 6 | 7+ | 8 | 9+ | 10+ | 11+ |
| Volume contraction ratio of curable component (A1) | 4 | 5 | 2 | 6 | 6 | 6 | 4 | 2 | - | 5 | - |
| Volume contraction ratio of curable component (B1) | 7 | 16 | 23 | 8 | 8 | 8 | 16 | 23 | 7 | - | 23 |
| Pseudo wafer warpage correction | ○ | ○ | ○ | ○ | ○ | ○ | ○ | ○ | △ | × | Peeled |
| Semiconductor chip adhesion | ○ | ○ | ○ | ○ | ○ | ○ | ○ | ○ | × | - | - |
| + Comparative Example | | | | | | | | | | | |

As obvious from Table 3, the pseudo wafers with the warpage correction layers formed by curing the individual curable resin compositions 1 to 8 by using different curing means, where the curable resin compositions 1 to 8 each contain a curable component to undergo volume contraction through a curing reaction and another curable component to undergo volume contraction through another curing reaction, provided goods results with enhanced capability to correct warpage and with no peeling defects found in the subsequent heat history during semiconductor mounting or reliability evaluations.

In contrast, the pseudo wafers with the warpage correction layers formed by using the individual curable resin compositions 9 to 11, each of which contains a curable component to undergo volume contraction through a curing reaction, but does not contain another curable component to undergo volume contraction through another curing reaction, were insufficient in capability to correct warpage. After subjected to further reactions so as to have enhanced capability of warpage correction, these pseudo wafers caused peeling defects found in the subsequent heat history during semiconductor mounting or reliability evaluations. In particular, the pseudo wafer with the warpage correction layer formed by using the curable resin composition 11 suffered partial peeling of the warpage correction layer, at the time of which the wafer was determined to be bad.

## Claims

1. A curable resin composition being curable through at least two types of curing reactions, the curable resin composition comprising:

   a combination of a curable component (A1) that contracts in volume through one curing reaction, a heat curing agent component (A2-1) capable of curing the curable component (A1), a curable component (B1) that contracts in volume through another curing reaction, and a light curing agent component (B2-2) capable of curing the curable component (B1),
   wherein the one curing reaction is an ionic ring-opening polymerization reaction or a polyaddition polymerization reaction, and the other curing reaction is a radical addition polymerization reaction,
   wherein a volume contraction ratio A (%) of the curable component (A1) that is cured through the ionic ring-opening polymerization reaction or the polyaddition polymerization reaction to contract in volume is within a range of $0 < A \leq 7$,
   wherein a volume contraction ratio B (%) of the curable component (B1) that is cured through the radical addition polymerization reaction to contract in volume is within a range of $5 \leq B \leq 30$, and
   wherein the volume contraction ratio A and the volume contraction ratio B satisfy an expression below and are determined as described in the description:

$$A < B.$$

2. Use of the curable resin composition according to claim 1 for forming a warpage correction layer that is disposed on a

face opposite to a face on which a redistribution layer of a fan-out wafer level package is disposed.

3. A fan-out wafer level package comprising:

a semiconductor chip, on one face of which a circuit is formed;
an encapsulant that seals the semiconductor chip such that at least a circuit terminal on the face on which the circuit is formed is exposed;
a redistribution layer disposed on a circuit forming face of the encapsulant; and
a warpage correction layer disposed on a face of the encapsulant, the face being opposite to the face on which the redistribution layer is disposed,
wherein the warpage correction layer comprises a cured product of the curable resin composition according to claim 1.

## Patentansprüche

1. Härtbare Harzzusammensetzung, die durch mindestens zwei Typen von Härtungsreaktionen härtbar ist, wobei die härtbare Harzzusammensetzung umfasst:

eine Kombination aus einer härtbaren Komponente (A1), die durch eine Härtungsreaktion im Volumen kontrahiert, einer Wärmehärtungsmittelkomponente (A2-1), die zum Härten der härtbaren Komponente (A1) geeignet ist, einer härtbaren Komponente (B1), die durch eine andere Härtungsreaktion im Volumen kontrahiert, und einer Lichthärtungsmittelkomponente (B2-2), die zum Härten der härtbaren Komponente (B1) geeignet ist,
wobei die eine Härtungsreaktion eine ionische Ringöffnungspolymerisationsreaktion oder eine Polyadditionspolymerisationsreaktion ist und die andere Härtungsreaktion eine radikalische Additionspolymerisationsreaktion ist,
wobei ein Volumenkontraktionsverhältnis A (%) der härtbaren Komponente (A1), die durch die ionische Ringöffnungspolymerisationsreaktion oder die Polyadditionspolymerisationsreaktion gehärtet wird, um im Volumen zu kontrahieren, innerhalb eines Bereiches von $0 < A \leq 7$ liegt,
wobei ein Volumenkontraktionsverhältnis B (%) der härtbaren Komponente (B1), die durch die radikalische Additionspolymerisationsreaktion gehärtet wird, um im Volumen zu kontrahieren, innerhalb eines Bereichs von $5 \leq B \leq 30$ liegt und
das Volumenkontraktionsverhältnis A und das Volumenkontraktionsverhältnis B einen nachstehend Ausdruck erfüllen und wie in der Beschreibung beschrieben bestimmt werden:

$$A < B.$$

2. Verwendung der härtbaren Harzzusammensetzung gemäß Anspruch 1 zur Bildung einer Verformungskorrekturschicht, die auf einer Fläche angeordnet ist, die einer Fläche gegenüberliegt, auf der eine Umverteilungsschicht eines Fan-Out Wafer-Level Package angeordnet ist.

3. Fan-Out Wafer-Level Package, umfassend:

ein Halbleiterchip, auf dessen einer Seite ein Schaltkreis gebildet ist,
ein Verkapselungsmittel, das den Halbleiterchip so versiegelt, dass mindestens ein Schaltungsanschluss auf der Seite, auf der die Schaltung gebildet ist, freiliegt,
eine Umverteilungsschicht, die auf der schaltungsbildenden Seite des Verkapselungsmittels angeordnet ist, und
eine Verformungskorrekturschicht, die auf einer Seite des Verkapselungsmittels angeordnet ist, wobei die Seite der Seite gegenüberliegt, auf der die Umverteilungsschicht angeordnet ist,
wobei die Verformungskorrekturschicht ein gehärtetes Produkt der härtbaren Harzzusammensetzung gemäß Anspruch 1 umfasst.

## Revendications

1. Composition de résine durcissable qui est durcissable par au moins deux types de réactions de durcissement, la composition de résine durcissable comprenant :

une combinaison d'un composant durcissable (A1) qui se contracte en volume par une première réaction de durcissement, d'un composant agent de durcissement thermique (A2-1) capable de durcir le composant durcissable (A1), d'un composant durcissable (B1) qui se contracte en volume par une autre réaction de durcissement, et d'un composant agent de photo-durcissement (B2-2) capable de durcir le composant durcissable (B1),
dans laquelle la première réaction de durcissement est une réaction de polymérisation par ouverture de cycle ionique ou une réaction de polymérisation par polyaddition, et l'autre réaction de durcissement est une réaction de polymérisation par addition radicalaire,
dans laquelle un rapport de contraction volumique A (%) du composant durcissable (A1), qui est durci par la réaction de polymérisation par ouverture de cycle ionique ou par la réaction de polymérisation par polyaddition, pour se contracter en volume, se situe dans une plage de $0 < A \leq 7$,
dans laquelle un rapport de contraction volumique B (%) du composant durcissable (B1), qui est durci par la réaction de polymérisation par addition radicalaire, se situe dans une plage de $5 \leq B \leq 30$, et
dans laquelle le rapport de contraction volumique A et le rapport de contraction volumique B satisfont à une expression ci-dessous et sont déterminés comme décrit dans la description :

$$A < B.$$

**2.** Utilisation de la composition de résine durcissable selon la revendication 1 pour former une couche de correction de déformation qui est disposée sur une face opposée à celle sur laquelle est disposée une couche de redistribution d'un boîtier sur tranche écarté en éventail.

**3.** Boîtier sur tranche écarté en éventail comprenant :

une puce semi-conductrice, sur une face de laquelle est formé un circuit ;
un encapsulant qui scelle la puce semi-conductrice de sorte qu'au moins une borne de circuit sur la face sur laquelle est formé le circuit est exposée ;
une couche de redistribution disposée sur une face de formation de circuit de l'encapsulant ; et
une couche de correction de déformation disposée sur une face de l'encapsulant, la face étant opposée à la face sur laquelle la couche de redistribution est disposée,
dans lequel la couche de correction de déformation comprend un produit durci de la composition de résine durcissable selon la revendication 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013038270 A
- JP 2012178422 A


### Non-patent literature cited in the description


- **CAROSCIA et al.** Evaluation and control of thiol-ene/thiol-epoxy hybrid networks. *Polymer*, March 2007, vol. 48 (6), 1526-1532
- **JIAN et al.** Thiol-epoxy/thiol-acrylate hybrid materials synthesized by photo polymerization. *Journal of Materials Chemistry C*, June 2013, vol. 1, 4481-4489